# EUROPEAN PATENT SPECIFICATION

(11) **EP 4 625 498 B1**
(45) Date of publication and mention of the grant of the patent: **25.11.2026**
(21) Application number: 24167815.0
(22) Date of filing: 28.03.2024
(51) Int. Cl.: H10D 30/43, H10D 30/47, H10D 62/13, H10D 62/80, H10D 30/67, H10D 62/10, H10D 99/00, H10D 30/01, H10D 84/01, H10D 84/02, H10D 84/85, H10D 84/03, H10D 84/83

(54) **METHOD FOR FORMING A 2D CHANNEL FIELD-EFFECT TRANSISTOR DEVICE**
VERFAHREN ZUR HERSTELLUNG EINER 2D-KANAL-FELDEFFEKT-TRANSISTORVORRICHTUNG
PROCÉDÉ DE FORMATION D'UN DISPOSITIF À TRANSISTOR À EFFET DE CHAMP À CANAL 2D

(43) Date of publication of application: 01.10.2025
(73) Proprietor: IMEC VZW, 3001 Leuven (BE)
(72) Inventor: GHOSH, Souvik, 3220 Holsbeek (BE); SCHRAM, Tom, 1330 Rixensart (BE); BREMS, Steven, 3010 Kessel-Lo (BE)
(74) Representative: Lind Edlund Kenamets Intellectual Property AB

(56) References cited:
- US-A1- 2022 399 330
- US-A1- 20240 096 960

## Description

### TECHNICAL FIELD

The present invention generally relates to a method for forming a 2D channel field-effect transistor (FET) device.

### BACKGROUND

Modern semiconductor and integrated circuit technology includes Si-based horizontal channel transistors, for example the horizontal or lateral nanosheet field-effect transistor (NSHFET). A NSHFET includes a source, a drain, a channel comprising one or more nanosheet-shaped horizontally extending channel layers and a gate stack. In a gate-all-around (GAA) design, the gate stack wraps all-around the channel layers.

At the aggressively scaled gate lengths of advanced technology nodes, such as below 10 nm gate lengths, it is becoming increasing challenging to further scale Si-based NSHFET devices, e.g., due to reduced channel control. These gate lengths may require sub-5 nm thick Si channels. However, both process-induced Si consumption, short channel effects and the changing behavior of ultrathin Si channels can limit the feasibility of Si channel length and thickness scaling.

In the strive to enable further scaled and more efficient nanosheet devices, there is considerable interest in finding materials to replace Si-based materials as channel material. A promising group of candidate materials for the channel layers is 2D materials. 2D materials, such as transition metal dichalcogenides (TMDs or MX2, where M is a metal such as W or Mo, and where X is a chalcogen such as sulfur or selenide) offer several advantages when compared to traditional three-dimensional bulk materials like Si. For instance, enabling very thin channel layers (e.g., a few monolayers), high electron mobility, precise electrostatic control, favorable on-off ratios, to name a few.

While 2D materials such as TMDs have appealing properties as a channel material in NSHFETs, introducing 2D materials in the integration stacks results in new challenges and considerations for device fabrication.

US 2024/096960 A1 discloses a method for forming a GAA gate structure by embedding a layer stack comprising 2D materials in a dummy dielectric layer. The dummy dielectric layer is used to first manufacture S/D cavities as well as subsequently manufacture a further gate cut insulating pattern defining a gate cavity. Inside the gate cavity, a gate structure is formed.

US 2022/399330 A1 discloses the manufacturing of a field-effect transistor comprising 2D semiconductor channels including forming an oxide liner by oxidizing a silicon-silicon germanium semiconductor layer stack.

### SUMMARY

According to an aspect of the present invention, there is provided a method for forming a 2D channel field-effect transistor device, the method comprising:
forming a device layer stack on a substrate, the device layer stack comprising lower and upper sacrificial layers of a sacrificial material and a channel layer of a 2D material arranged between the lower and upper sacrificial layers, wherein the device layer stack extends in a first direction between a first source/drain side and a second source/drain side;
embedding the device layer stack in a dummy layer of a dummy semiconductor material;
forming a gate cavity in the dummy layer, the gate cavity extending in a second direction transverse to the first direction, and exposing the device layer stack along a channel region between the first and second source/drain side;
removing the sacrificial layers from the device layer stack by selectively etching the sacrificial material from the gate cavity;
after removing the sacrificial layers, forming an oxide liner along sidewalls of the gate cavity, wherein forming the oxide liner comprises performing an oxidation process to oxidize a thickness portion of the dummy layer along the sidewalls of the gate cavity;
forming a gate stack in the gate cavity to surround the channel layer along the channel region, wherein the oxide liner separates the gate stack from the dummy layer;
forming source/drain contact cavities in the dummy layer, on the first and second source/drain sides;
forming source/drain contacts in the source/drain contact cavities, in contact with the channel layer; and
after forming the source/drain contacts, replacing the dummy layer with a dielectric layer.

Embedding the device layer stack in a dummy layer of a dummy semiconductor material prior to gate cavity formation and sacrificial layer removal (i.e., "channel release" or "nanosheet release"), instead of an oxide-comprising inter-layer dielectric (as typically is done in conventional fabrication of Si-based devices), enables the sidewalls of the gate cavity to be lined with a continuous oxide liner. The gate cavity, and hence also the gate stack subsequently formed therein, may thus be surrounded by the oxide liner, which may provide a process and isolation margin between the gate stack (e.g., gate metal) and the adjacent structures, in particular the source/drain contacts.

By the term "dummy semiconductor material" is here meant a 3D semiconductor material or bulk semiconductor material (i.e., a non 2D semiconductor material). The dummy semiconductor material may typically be a Si-, Ge- or SiGe-based material, monocrystalline or polycrystalline (e.g., epitaxial Si, Ge or SiGe), or amorphous (e.g., a-Si).

By removing the sacrificial layers from the device layer stack, portions of the sidewalls of the gate cavity initially abutting ends of the sacrificial layers facing the first and second source/drain sides may be exposed. The oxide liner may thus be formed also along these exposed portions of the sidewalls, such that the oxide liner may extend continuously along the sidewalls of the gate cavity and the gate stack facing the first and second source/drain sides. As further set out below, the oxide liner formed may in some embodiments remain along the sidewalls of the gate cavity and the gate stack facing the first and second source/drain sides, after forming the source/drain contacts, and thus further function as an inner spacer, providing a lateral spacing and isolation between the source/drain contacts and the gate stack.

The method of the present aspect is compatible with various species of 2D channel materials. **In** some embodiments, the 2D channel material may be a transition metal dichalcogenide, such as molybdenum disulfide, tungsten disulfide, molybdenum diselenide or tungsten diselenide. **In** other embodiments the 2D channel material may be black phosphorous.

By the term "device layer stack" is here meant a sequence of layers stacked vertically on top of each other. The sacrificial and channel layers may each be horizontally oriented, i.e. have a main plane of extension parallel to the substrate. The sacrificial and channel layers may for example each be provided in the shape of nanosheets.

By the term "gate cavity" is herein meant a trench, opening or hole which is formed in the dummy layer adjacent to and along the channel region of the device layer stack such that the device layer stack is exposed along the channel region via the gate cavity. **In** other words, the gate cavity will expose the device layer stack along the channel region from at least one sidewall thereof such that the device layer stack is accessible via the gate cavity. The gate cavity may, in particular, extend across the device layer stack. The gate cavity may thus expose the device layer stack from two opposite sidewalls of the device layer stack. These sidewalls may be referred to as the lateral walls of the device layer stack.

By the term "source/drain contact cavity" is correspondingly meant a trench, opening or hole which is formed in the dummy layer adjacent to the device layer stack on the first or second source/drain side thereof. A source/drain contact cavity formed on the first or second source/drain side may, in particular, be formed along, and typically expose, a sidewall of the device layer stack facing the given source/drain side. The respective sidewalls of the device layer stack facing the first and second source/drain sides may herein be referred to as the end walls of the device layer stack.

In some embodiments, the oxidation process is a plasma oxidation process. A plasma oxidation process may be performed in a manner being relatively benign to the exposed structures and materials, such that a growth rate of the oxide liner may be controlled and a risk of oxidizing materials which are not to be oxidized (e.g. the channel material, and gate dielectric where present on the channel layer) may be mitigated. The plasma oxidation process may thus be performed to achieve a surface oxidation of the dummy layer, with a target thickness or "depth". The plasma oxidation process may in particular be a room-temperature plasma oxidation process.

**In** some embodiments, the gate cavity comprises first and second opposite sidewalls extending along the first and second source/drain sides, respectively, and third and fourth opposite sidewalls connecting the first and second sidewalls at opposite ends of the gate cavity, wherein the oxide liner is formed to extend along each of the first, second, third and fourth sidewalls of the gate cavity. The oxide liner may thus be formed to extend continuously to surround or circumscribe the gate cavity.

In some embodiments, the third sidewall connects to the first and second sidewalls in respective corner regions of the gate cavity, and the source/drain contact cavities are formed along the first and second sidewalls of the gate cavity, adjacent a respective one of the corner regions.

The source/drain contact trenches and contacts may thus be formed at or close to a terminal end or cut in the gate stack. This may be useful to form 2D channel FET devices with small gate extensions. The term "gate extension" is herein used to refer to the extension of the gate stack (e.g., the gate metal of the gate stack) past a lateral wall of the device layer stack, along the second direction. A "small" gate extension may in this context be understood as a gate extension which is approximately equal to, or within, the margin of alignment errors for forming the source/drain contact cavities.

Hence, where one, or both, of the source/drain contact cavities extend(s) past (and thus along) the respective corner regions of the gate cavity (e.g., due to an alignment error when lithographically patterning the source/drain contact cavities), the oxide liner portion along the respective corner region may still provide a physical and electrical separation between the respective source/drain cavity and corner region.

Designating the portions of the gate stack formed in the respective corner regions of the gate cavity as "corner portions" of the gate stack, the oxide liner portions along the corner portions of the gate stack may correspondingly provide a physical and electrical separation towards the respective source/drain contacts.

In some embodiments, the device layer stack further comprises a gate dielectric layer encapsulating the channel layer, wherein the gate dielectric layer and the channel layer are arranged between the lower and upper sacrificial layers.

The channel layer may thus be surrounded by the gate dielectric layer on all sides. The channel layer may hence be protected or masked from potentially adverse processing conditions. This may be beneficial as 2D materials are generally more delicate and hence more prone to being damaged during processing than silicon.

Moreover, the presence of the gate dielectric layer may provide a structural support for the atomically thin channel layer, hence mitigating a risk of deformation due to sagging (i.e., bending) of the channel layer after the sacrificial layers have been removed to release the channel layer.

In some embodiments, forming the device layer stack comprises:
forming an initial device layer stack comprising, in sequence, the lower sacrificial layer, a lower gate dielectric layer portion, the channel layer, an upper gate dielectric layer portion and the upper sacrificial layer;
forming a recess in the initial device layer stack by etching back at least the channel layer, and optionally also the gate dielectric layer portions, relative the sacrificial layers; and
forming a side gate dielectric layer portion in the recess, wherein the side gate dielectric layer portion connects the upper and lower gate dielectric layer portions to form the gate dielectric layer encapsulating the channel layer.

The initial device layer stack may hence be provided merely as a vertical stack of layers, e.g., a stack of nanosheets, for instance formed using process techniques such as growth, transfer and layer bonding. From this initial device layer stack, the channel layer may be encapsulated by gate dielectric by a combination of lateral selective etch back to form the recess between the sacrificial layers, followed by a deposition step to fill the recess with gate dielectric.

In embodiments where the channel layer is encapsulated by the gate dielectric layer, the method may further comprise recessing the gate dielectric layer from the source/drain contact trenches to expose a first end portion of the channel layer facing the first source/drain side and a second end portion of the channel layer facing the second source/drain side, wherein the source/drain contacts subsequently are formed in the source/drain contact cavities, in contact with the exposed first and second end portions of the channel layer. The opposite first and second end portions of the channel layer may hence be covered by the gate dielectric until just prior to being contacted with the source/drain contacts.

In some embodiments, the method further comprises:
after removing the sacrificial layers and prior to forming the oxide liner, extending the dummy layer by selectively growing an auxiliary dummy semiconductor material on the dummy layer, including on the sidewalls of the gate cavity,
wherein the sidewalls of the gate cavity comprise a first sidewall extending along the first source/drain side and a second sidewall extending along the second source/drain side,
wherein the channel layer comprises a first end portion facing the first source/drain side and a second end portion facing the second source/drain side,
wherein the auxiliary dummy semiconductor material grows laterally from the first and second sidewalls to surround the first and second end portions of the channel layer from above and below, and
wherein the thickness portion of the dummy layer oxidized when performing the oxidation process comprises a thickness portion of the auxiliary dummy semiconductor material.

The dummy layer may hence be provided with an auxiliary (i.e., additional) thickness portion of auxiliary dummy semiconductor material. The horizontal footprint of the gate cavity may thus be trimmed. More specifically, the extension along the first direction (i.e., along the channel region) of the spaces above and below the channel layer defined by removing the sacrificial layers may thus be reduced from the first and second source/drain sides. As these spaces are to be filled with the gate stack, the auxiliary dummy semiconductor material of the dummy layer allows a gate length of the gate stack to be trimmed. In addition to creating an additional physical separation between the gate stack and the source/drain contact trenches and contacts, the oxidized thickness portion of the auxiliary dummy semiconductor material may surround the first and second end portions of the channel layer from above and below, thus defining "inner spacers" towards the first and second source/drain sides.

It is to be noted that the auxiliary dummy semiconductor material and the dummy semiconductor material of the initially formed dummy layer (which in the following may be termed "first dummy semiconductor material") may be a same material (i.e., a material of a same type). The first and auxiliary semiconductor materials may in other examples be different semiconductor materials. In either case, the auxiliary dummy semiconductor material refers, like the first dummy semiconductor material, to a 3D or bulk semiconductor material (e.g., epitaxial Si, Ge or SiGe, or a-Si), which may be grown or deposited in an area selective manner on the dummy layer.

Here, the area selectivity may be facilitated by that the channel layer is of a 2D channel material, and hence present a certain inherent inertness to the growth of the (non 2D material) auxiliary dummy semiconductor material. The selectivity may also be provided where the channel layer is encapsulated by the gate dielectric layer, in accordance with embodiments set out above, with the additional effect of the channel layer being shielded from direct exposure to the process conditions of the deposition process.

In some embodiments, the source/drain contact cavities in the dummy layer are separated from the gate stack by the oxide liner and a non-oxidized thickness portion of the auxiliary dummy semiconductor material. The source/drain contact cavities are hence separated from the gate stack by both the inner spacers and non-oxidized auxiliary dummy semiconductor material remaining after the oxidation process.

In some embodiments, replacing the dummy layer with a dielectric layer comprises removing the dummy layer, including the non-oxidized thickness portion, using a selective etching process, and subsequently depositing the dielectric layer.

Hence, remaining non-oxidized dummy material (first and auxiliary) of the dummy layer may be selectively removed and replaced with dielectric material.

In some embodiments, the method further comprises, after forming the source/drain contact cavities and prior to forming the source/drain contacts:
recessing the oxide liner from the source/drain contact cavities to expose sidewall portions of the gate stack and subsequently recessing the exposed sidewall portions of the gate stack, to form source/drain recesses; and
forming inner spacers covering the recessed sidewall portions of the gate stack and filling the source/drain recesses.

This may represent an alternative to the above discussed embodiments comprising extending the dummy layer by growth of auxiliary dummy semiconductor material.

The gate length of the gate stack (along the first direction) may hence be trimmed by, first, a lateral recess of the oxide liner, and then, of the gate stack from the first and second source/drain sides. Inner spacers may then be formed by filling the source/drain recesses with an insulating inner spacer material. The inner spacers may connect with remaining portions of the oxide liner exposed adjoining the source/drain recesses, such that the gate stack may be circumscribed by a continuous composite insulating layer formed by the portions of the oxide liner and the inner spacers.

In some embodiments, the gate dielectric layer is recessed to expose the first and second end portions of the channel layer after forming the inner spacers. Hence, the end portions of the channel layer may be shielded from the process conditions during the deposition of the inner spacer material, and further during a subsequent etch back of the inner spacer material which typically may be applied to remove inner spacer material deposited outside the source/drain recesses.

### BRIEF DESCRIPTION OF THE DRAWINGS

This and other aspects of the present invention will now be described in more detail, with reference to the appended drawings.
Fig. 1a-c show a top-down view and first and second cross-sectional views of an initial or starting structure of a semiconductor device for a method for forming a 2D channel FET device.
Fig. 2a-c through Fig. 17a-c show corresponding views of the device structure at various stages of the method according to a first approach.
Fig. 18a-c through Fig. 26a-c show various stages of the method according to a second approach.

### DETAILED DESCRIPTION

The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first direction, a second direction, and a vertical direction, respectively. The first and second directions X, Y are more specifically first and second horizontal directions.

As used herein, the term "horizontal" refers to a direction parallel to a substrate of the device structure, i.e. parallel to a main surface of the substrate, or equivalently, parallel to an in-plane direction of the layers of the device layer stack. The term "lateral" refers to a direction or orientation along a horizontal plane. The term "vertical" refers to a direction normal or transverse to the substrate, or equivalently to the direction along which the layers of the device layer stack are stacked. Accordingly, terms indicating relative vertical arrangement of elements, such as "top", "upper", "bottom", "lower" and the like, are to be understood in relation to the vertical direction relative the substrate, or relative the layer stack.

It is to be noted that when an element (e.g. a layer or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element.

It is further to be noted that terms such as "first" and "second" etc. with reference to elements (e.g. layers or other structures) or, as the case may be, process steps are used herein only as labels to facilitate distinguishing between different elements, and need not necessarily imply that such elements or process steps are arranged or performed in that particular order, unless stated otherwise.

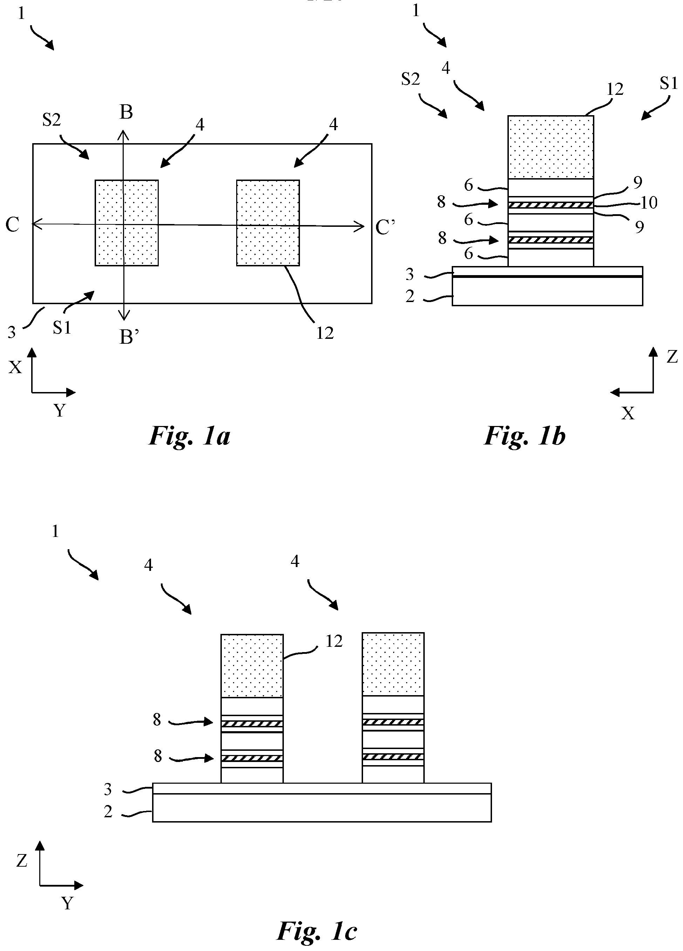

Fig. 1a-c schematically show a device structure 1 representing an initial or starting structure, to be subjected to process steps disclosed in the following. The device structure 1 comprises a substrate 2 and a number of device layer stacks 4 in an initial form, i.e., an initial device layer stack 4. Reference will in the following mainly be made to a single device layer stack 4, however the method may be applied in parallel to a number of corresponding device layer stacks 4 provided on the substrate 2.

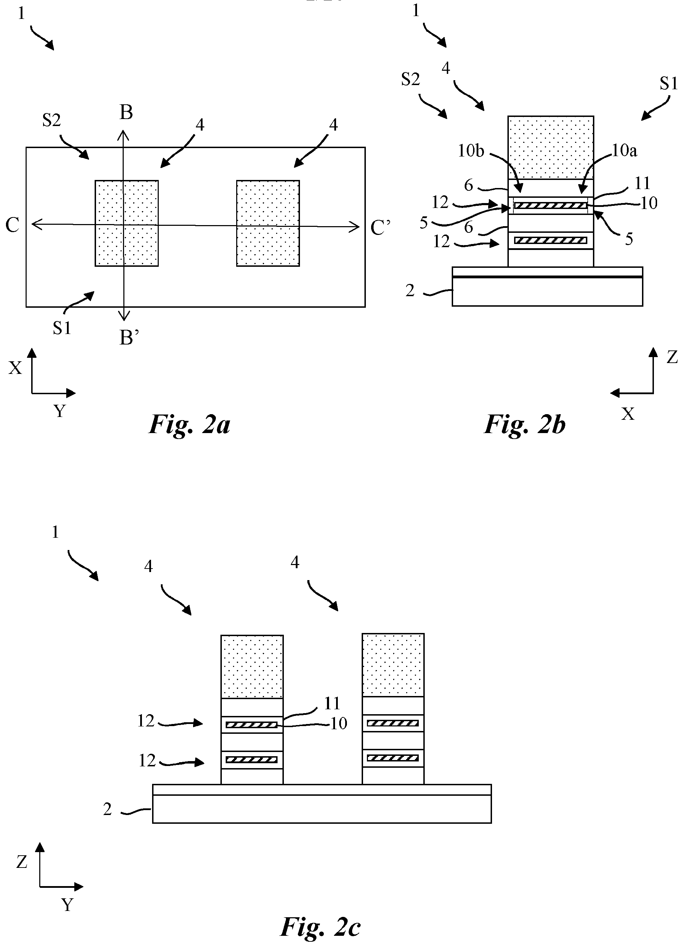

Fig. 1a shows a top-down view of the device structure 1. Fig. 1b shows a first cross-section of the device structure 1 along line B-B' indicated in Fig. 1a. Fig. 1c shows a second cross-section of the device structure 1 along line C-C' indicated in Fig. 1a. This description of the respective views of Fig. 1a-c applies correspondingly to the subsequent figures 2a-c through 26a-c.

In the figures, reference signs S1 and S2 generally designate a first and a second source/drain side, respectively, of the device layer stack 4, that is, the sides of the device layer stack 4 on which the source/drain contacts of the 2D channel FET device are to be formed. The first direction X is thus parallel to an intended channel direction of the device to be formed (which corresponds to the first direction X), i.e., from the first source/drain side S1 to the second source/drain side S2.

The device structure 1 comprises a substrate 2. The substrate 2 may be a conventional substrate, suitable for semiconductor device processing. The substrate 2 may for instance be a Si substrate, a Ge substrate or a SiGe substrate. Other non-limiting examples include a silicon-on-insulator (SOI) substrate, a GeOI substrate or a SiGeOI substrate. A frontside of the substrate 2 may as shown be provided with an insulating layer 3. The insulating layer 3 may serve as a bonding layer for the device layer stack 4, and further function as a bottom isolation layer for the final device.

Unless stated otherwise, a process step described herein as being applied to a substrate may be applied to the entire substrate, or to only a portion of the substrate, such as a surface portion of the substrate. Moreover, a process step applied to a substrate, such as a depositing a layer on a substrate, may imply that the process step is applied to a bare substrate or to a substrate already provided with one or more layers or features, such as the insulating layer 3. This applies correspondingly to a structure (e.g., the device layer stack 4) arranged on a substrate (e.g., the substrate 2, with or without the insulating layer 3).

The device layer stack 4 is generally formed in the shape of a fin, i.e., a fin-shaped device layer stack 4. The device layer stack 4 extends between the first and second source/drain sides S1, S2 in the first direction X to define a length dimension of the device layer stack 4. The device layer stack 4 further has a width dimension along the second direction Y, wherein it is to be understood that length dimension may be either greater, smaller or substantially equal to the width dimension. The device layer stack 4 further has a height dimension along the vertical direction Z by which the device layer stack 4 protrudes above its supporting surface, e.g., the frontside of the substrate 2 or, where present, the insulating layer 3. The device layer stack 4 as depicted has two pairs of mutually opposite sidewalls (e.g., vertically oriented sidewalls). The pair of sidewalls facing the first and second source/drain sides S1, S2 will in the following be denoted end walls of the device layer stack 4. The pair of sidewalls of the layer stack 4 connecting the first and second end walls will be denoted lateral walls of the device layer stack 4.

The (initial) device layer stack 4 comprises a stack of sacrificial layers 6 and sub-stacks or layer units 8. Each sub-stack 8 is arranged between a pair of lower and upper sacrificial layers. Each sub-stack 8 comprises a channel layer 10 arranged between a pair of lower and upper gate dielectric layers 9, where the prefix "gate" signify that the dielectric layers 9 will be incorporated in the gate stack of the finished device. Each pair of sacrificial layers 6 and the gate dielectric and channel layers 8, 9 of the respective sub-stack 8 between the pair of sacrificial layers 6 may as shown form a consecutive layer sequence, e.g., in a bottom-direction, the lower sacrificial layer 6, the lower gate dielectric layer 9, the channel layer 10, the upper gate dielectric layer 9, and the upper sacrificial layer 6.

Each of the layers 6, 8, 9 of the device layer stack 4 may generally be formed in the shape of a nanosheet.

Each channel layer 10 is formed of a 2D channel material. The 2D channel material may be a transition metal dichalcogenide, such as molybdenum disulfide, tungsten disulfide, molybdenum diselenide or tungsten diselenide. A further example of a 2D material is black phosphorous. The 2D channel material may be deposited using any suitable conventional deposition process, such as chemical vapor deposition (CVD), physical vapor deposition (PVD), atomic layer deposition (ALD) or chemical vapor transfer (CVT). The 2D material may be deposited with a thickness of one to a few monolayers of the 2D material, e.g. corresponding to a thickness in a range of a few tenths of a nanometer to a few nanometers.

Each gate dielectric layer 9 is formed of a gate dielectric material. The gate dielectric material may be a high-k gate dielectric, such as HfO₂, HfSiO, LaO, Al₂O₃ or ZrO₂, or combinations thereof. The 2D material may be deposited using any suitable conventional deposition process, for instance a conformal deposition process such as ALD. The gate dielectric material may be deposited with a thickness in a range of 1-5 nm, such as an equivalent oxide thickness of 2 nm or less. This thickness range may result in the dielectric layers 9 suitable for use as a gate dielectric in a 2D channel FET device.

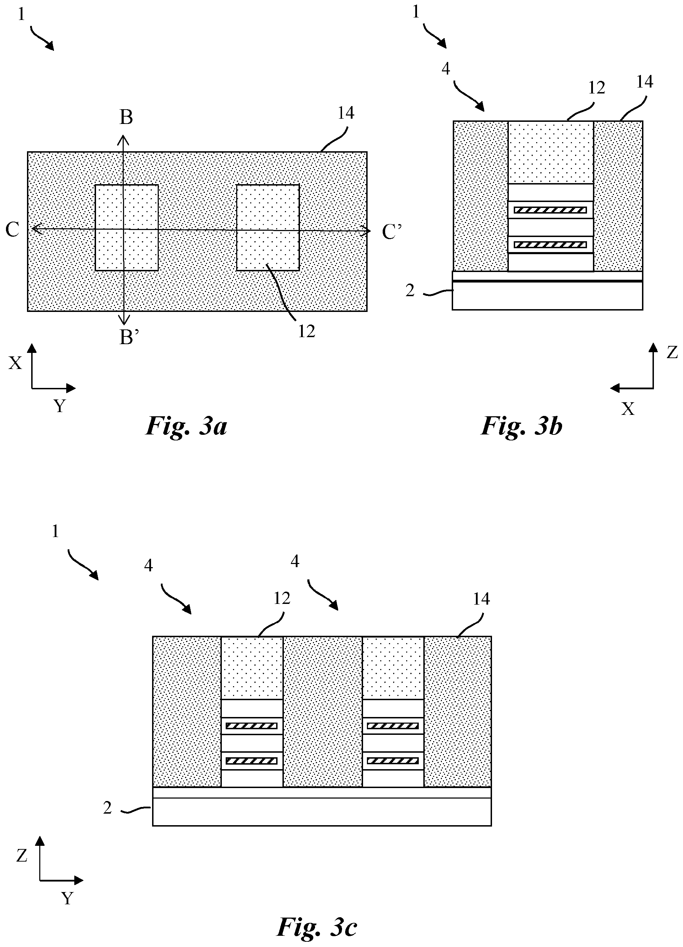

Each sacrificial layer 6 is formed of a sacrificial material. The sacrificial material is chosen as a material being etchable selectively to the 2D channel material, the gate dielectric material, and also to a dummy material of a dummy layer 14 (discussed below with reference to Fig. 3), such that the sacrificial material may be etched and/or removed selectively to the channel material, the gate dielectric material and the dummy material (i.e., using an etch process with a sufficient selectivity to the sacrificial material).

The sacrificial material may be a sacrificial dielectric such as, SiO₂, AlN, SiN, TiN, Al₂O₃ or a combination thereof. The sacrificial material may also be a sacrificial semiconductor, e.g., a bulk or 3D semiconductor such as Si, SiGe or Ge, either epitaxial or amorphous. The sacrificial material may be deposited using any suitable conventional deposition processes, such as CVD, PVD or ALD.

The device layer stack 4 may be formed using a combination of process techniques such as layer growth, layer transfer and layer bonding, followed by fin patterning.

For example, a 2D channel layer structure may be formed on the substrate 2.

A first layer stack may be formed on a growth wafer (e.g., a sapphire wafer) by:
growing an initial 2D channel layer on a growth surface of the growth wafer,
forming an initial gate dielectric layer of the gate dielectric material on a first major surface of the initial 2D channel layer and
forming an initial sacrificial layer of the semiconductor (i.e., the non 2D semiconductor) on a major surface of the initial gate dielectric layer.

The first layer stack may then be bonded to the substrate 2 with the initial sacrificial layer facing the substrate 2.

The growth wafer may subsequently be debonded from the layer stack. The debonding may be achieved using a mechanical debonding process. To further reduce the bonding force between the initial channel layer and the growth wafer, and thus facilitate a mechanical debonding, the interface between the initial channel layer and the growth wafer may optionally be intercalated by water (e.g. de-ionized water or ultra-pure water to mitigate a risk of contaminating the initial channel layer).

It is contemplated that some bulk / 3D semiconductors may allow the sacrificial layer to induce stress at an interface between the growth wafer and the initial channel layer, which may facilitate debonding using a mechanical debonding process.

After debonding the growth wafer from the first layer stack, a second initial gate dielectric layer of the gate dielectric material may be formed on a second major surface of the initial 2D channel layer, followed by a further sacrificial layer on a major surface of the second initial gate dielectric layer.

A second layer stack may further be performed in a similar manner as the first layer stack, namely growing an initial 2D channel layer on a growth surface of a second growth wafer (e.g., sapphire), forming an initial gate dielectric layer of the gate dielectric material on a first major surface of the initial 2D channel layer, and forming an initial sacrificial layer of the semiconductor (i.e., the non 2D semiconductor) on a major surface of the initial gate dielectric layer.

The second layer stack may then be bonded to the first layer stack such that the second initial sacrificial layer and the initial sacrificial layer of the second layer stack are directly bonded to each other to form a common second initial sacrificial layer.

The second growth wafer may thereafter be debonded from the second layer stack in a manner corresponding to the debonding of the first growth wafer such that the second growth wafer is released from the initial channel layer of the second layer stack.

These process steps may be repeated a number of times to obtain a 2D channel layer structure comprising a desired number of initial channel layers.

It is to be noted that the above outlined process merely is an example, and that any other sequence of process steps allowing a 2D channel layer structure with the disclosed composition of layers may be employed. For instance, each initial 2D channel layer may be grown on a respective growth wafer, be exfoliated from the growth wafer, e.g., using a thermal release tape, and transferred to the substrate 2. The thermal release tape may then be removed, wherein a first initial gate dielectric layer, an initial sacrificial layer, and then a second initial gate dielectric layer may be deposited thereon. This may be repeated a number of times

In any case, the stack of layers of the 2D channel layer structure may subsequently be patterned to form a plurality of fin-shaped device layer stacks 4, as shown in Fig. 1a-c. Any conventional single- or multiple-patterning techniques used for fin patterning may be used. Reference sign 12 indicates a hard mask (e.g., a nitride- or oxide-based hard mask layer) remaining on top of each device layer stack 4 after patterning. The hard mask 12 may as will become apparent from the following, remain on each device layer stacks 4 during at least a subset of the process steps.

In the depicted example, the device layer stack 4 comprises three sacrificial layers 6 and two sub-stacks 8. This is however merely an example and a device layer stack may comprise fewer or greater number of sacrificial layers and sub-stacks, however at least one pair of lower and upper sacrificial layer, and a sub-stack arranged between the pair of sacrificial layers. For conciseness, reference will in the following mainly be made to a single pair of sacrificial layers 6, a single channel layer 10 and a single pair of dielectric layers 9 (and from Fig. 2 and onwards a single dielectric layer 11). It is however to be understood that the following discussion may apply correspondingly to any additional such layers of the device layer stack 4.

In Fig. 2, the channel layer 10 has been encapsulated on all sides by a gate dielectric layer 11. Each sub-stack 8 has thus been processed to form a respective sub-stack 12 comprising a respective gate dielectric layer 11 and a respective channel layer 10 encapsulated by the dielectric layer 11. The sub-stack 12 is like the sub-stack 8 arranged between the lower and upper sacrificial layers 6. The encapsulating dielectric layer 11 may, among others, protect or mask the channel layer 10 from potentially adverse processing conditions during the below described process steps.

As schematically indicated in Fig. 2b, the channel layer 10 may be encapsulated by the gate dielectric layer 11 by forming a recess 5 in the device layer stack 4 by etching back at least the channel layer 10, and optionally also the gate dielectric layer portions 9, relative the sacrificial layers 6.

The recess 5 may be formed by laterally etching the channel layer 10, and optionally the gate dielectric layers 9, from the end walls and lateral walls of the device layer stack 4. The lateral etch back may be achieved by an isotropic etching process. The etching process may be any suitable conventional dry etching process or wet etching process allowing selective etching of the 2D channel material, and optionally the gate dielectric material, without causing any appreciable etch back of the sacrificial layers 6.

A side gate dielectric layer portion may subsequently be formed in the recess 5, wherein the side gate dielectric layer portion connects the (recessed) upper and lower gate dielectric layer portions 9 to form the gate dielectric layer 11 encapsulating the channel layer 10. The side gate dielectric layer portion may like the gate dielectric layers 9 be formed of a high-k dielectric material, such as any of the examples of high-k dielectrics mentioned above, typically, a same material species as the gate dielectric layers 9 to obtain a continuous gate dielectric layer 11 with substantially uniform properties along the encapsulated channel layer 10. The side gate dielectric layer portion may be formed by depositing the gate dielectric material conformally, e.g., using ALD, to fill the recess 5. Portions of the gate dielectric material deposited outside the recess 5 may subsequently be removed by etching the gate dielectric material using an isotropic etch until the sacrificial layers 6 are exposed along the end walls and lateral walls of the device layer stack 4.

Since the device layer stack 4 is exposed along its full circumference, the recess 5 is formed in each of the end walls and the lateral walls of the device layer stack 4. The recess 5 is thus formed as a circumferentially extending recess. Correspondingly, the side gate dielectric layer portion of the gate dielectric layer 11 extends circumferentially about the channel layer 10, along each of the end walls and the lateral walls of the device layer stack 4. In particular, the gate dielectric layer 11 as depicted covers each of a first end portion 10a of the channel layer 10 facing the first source drain side S1, and a second end portion 10b of the channel layer 10 facing the second source drain side S2.

Process steps of a method of a first approach which may be applied to the device structure 1 comprising the substrate 2 and the device layer stack 4, as shown in Fig. 2a-c, will now be disclosed with reference to Fig. 3a-c through Fig. 17a-c.

In Fig. 3a-c, the device layer stack 4 has been embedded in a dummy layer 14 of a dummy semiconductor material.

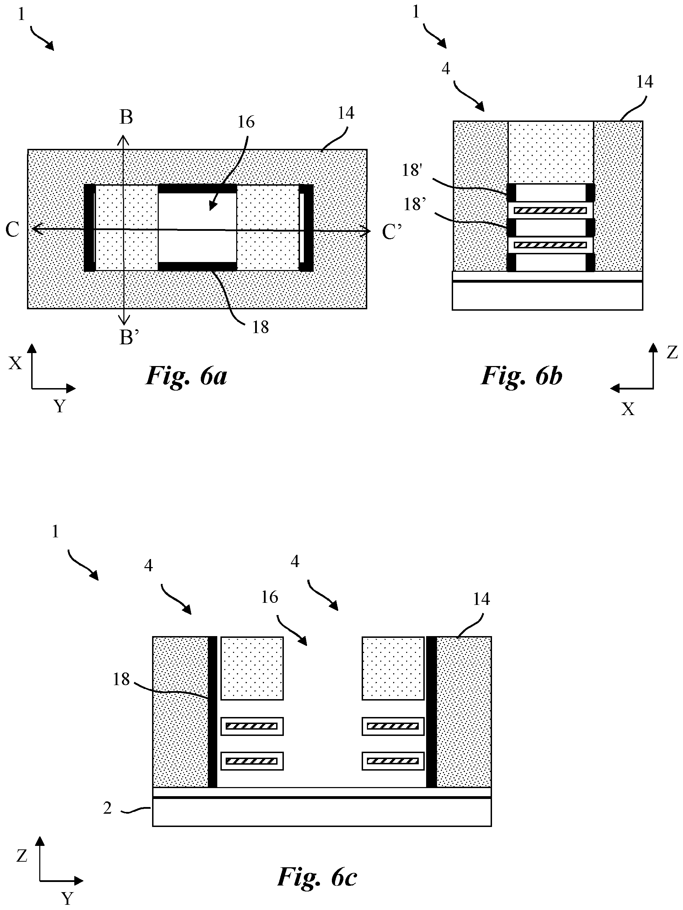

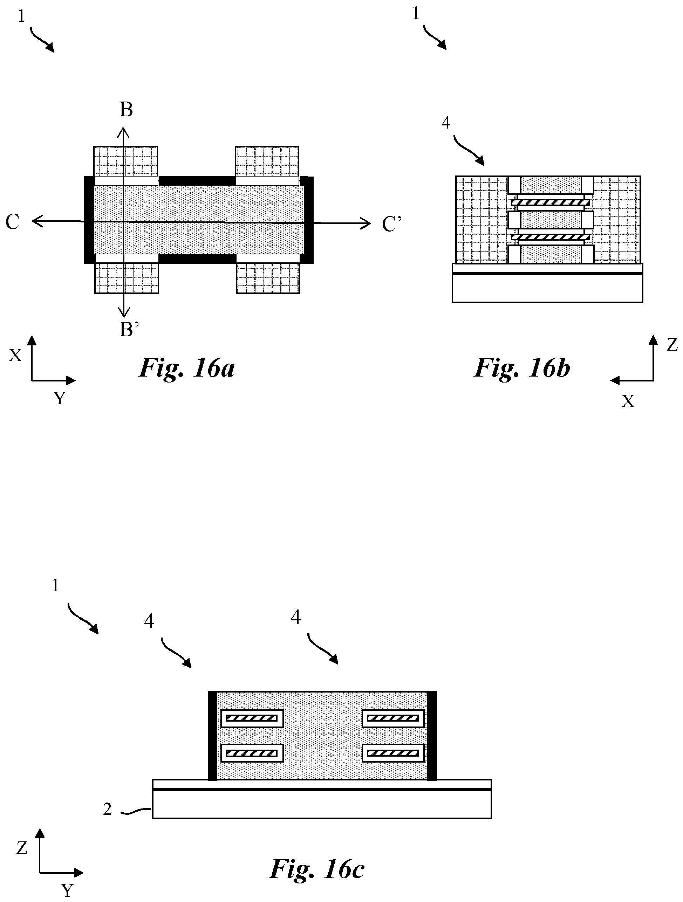

The dummy semiconductor material may be a Si-, Ge- or SiGe-based material, deposited in monocrystalline polycrystalline (e.g., epitaxial Si, Ge or SiGe), or amorphous (e.g., a-Si) form. The dummy semiconductor material may more generally be chosen as any suitable bulk or 3D semiconductor having a lower oxidation temperature and lower oxidation rate than the 2D channel material, such that an oxide liner 18 (see Fig. 6a-c) may be formed using an oxidation process in an area selective manner along the dummy layer 14, without causing any appreciable co-deposition on other surfaces or oxidation of 2D channel material. The dummy semiconductor material may further be chosen so as to be etchable with a relatively high selectivity towards typical high-k gate dielectrics, thus facilitating the subsequent removal of the dummy layer 14, see Fig. 16a-c. A dummy semiconductor material of a-Si may for example be a rational choice as it may be deposited quickly and inexpensively.

The dummy semiconductor material may be deposited using any suitable conventional deposition process, such as CVD or PVD. The deposited dummy semiconductor material may subsequently be planarized (e.g., by chemical mechanical polishing (CMP)) to produce a planarized top surface flush with a top surface of the hard mask 12, as shown in Fig. 3a-c.

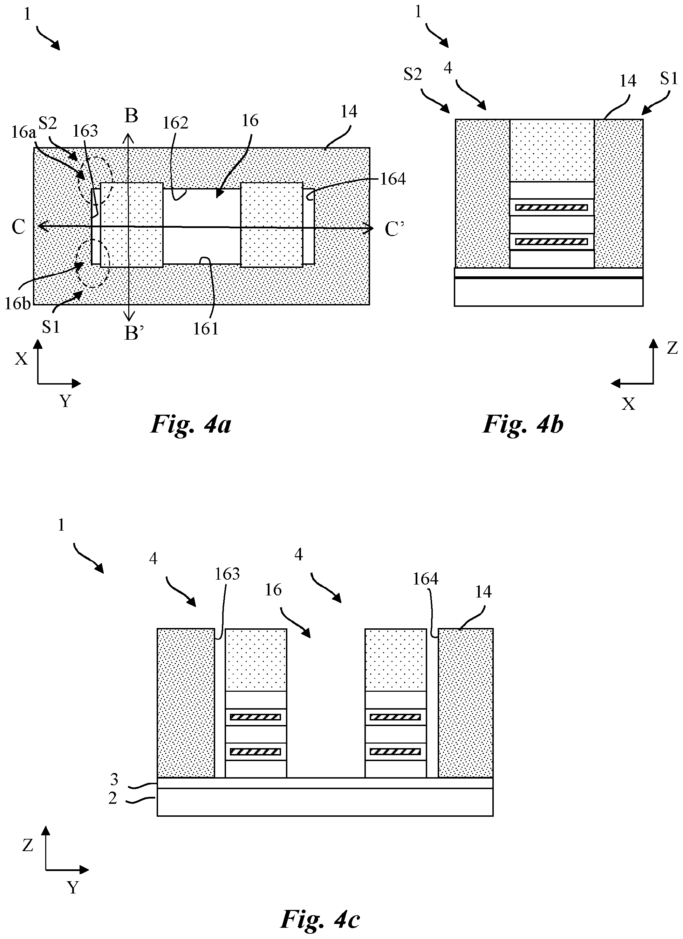

In Fig. 4a-c, a gate cavity or gate trench 16 has been formed in the dummy layer 14. The gate cavity 16 extends in the second direction Y transverse to the first direction X, and exposes the device layer stack 4 along a channel region between the first and second source/drain sides S1, S2.

The gate cavity 16 comprises first and second opposite sidewalls 161, 162 extending along the first and second source/drain sides S1, S2, respectively. The first and second sidewalls 161, 162 may as shown extend along the second direction Y. The gate cavity 16 further comprises third and fourth opposite sidewalls 163, 164 connecting the first and second sidewalls 161, 162 at opposite ends of the gate cavity 16. The third and fourth sidewalls 163, 164 may as shown extend along the first direction X.

The third sidewall 163 connects to the first and second sidewalls 161, 162 in respective corner regions 16a, 16b of the gate cavity 16. Correspondingly, the fourth sidewall 164 connects to the first and second sidewalls 161, 162 in corresponding respective corner regions 16a, 16b at the opposite end of the gate cavity 16.

The sidewalls 161, 162, 163, 164 may as shown be substantially vertically oriented, e.g., extend along the vertical direction Z.

The gate cavity 16 may be formed by a lithography and etching process. Any suitable conventional anisotropic etching process, wet or dry, with a sufficient selectivity towards the dummy semiconductor material may be used. The etch may be stopped on the substrate 2 or, where present, the insulating layer 3.

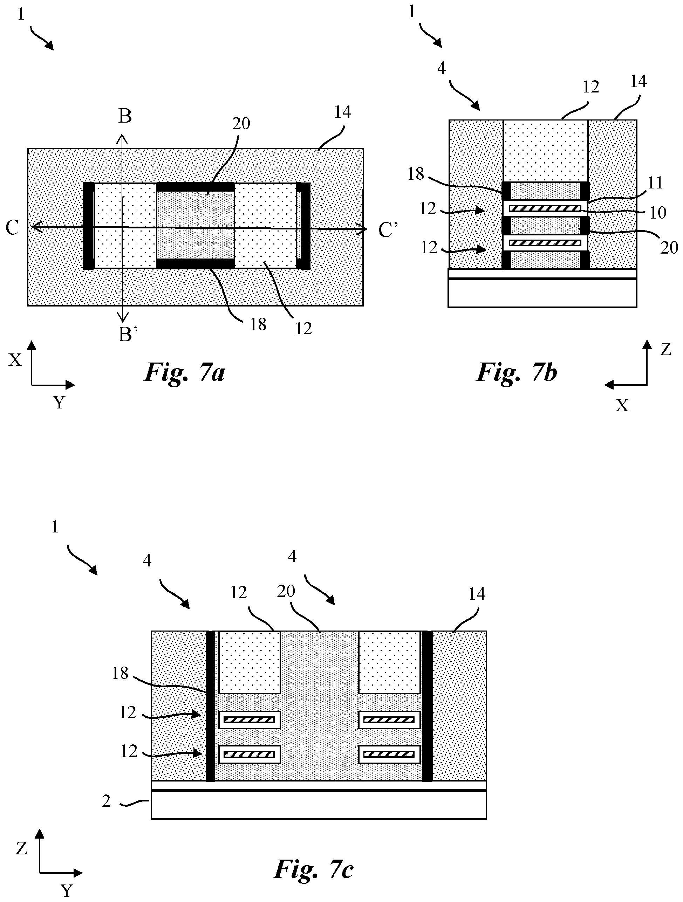

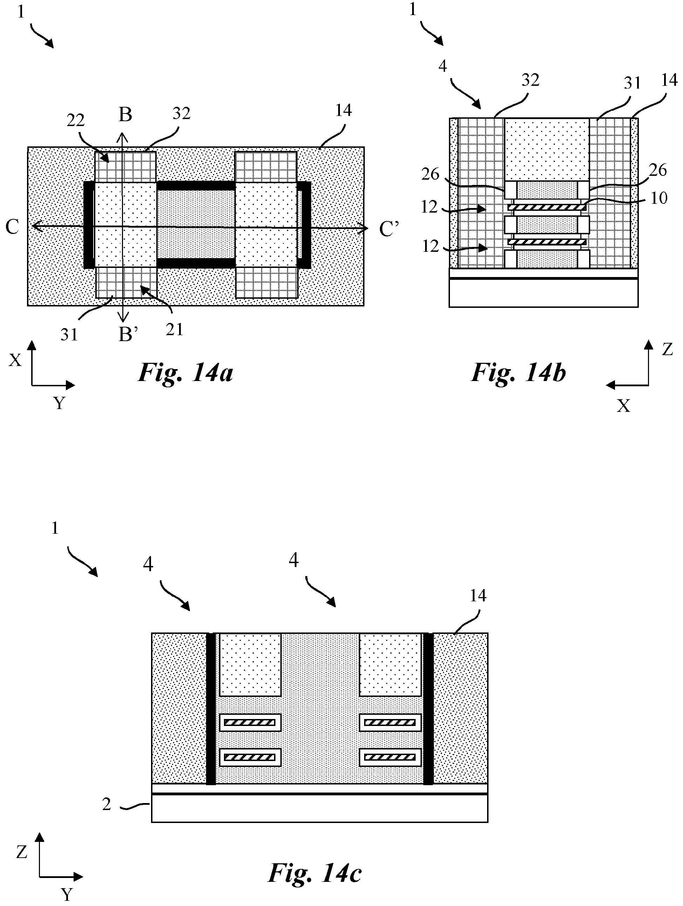

In the illustrated example, the gate cavity 16 is formed with a width dimension (along the first direction X) smaller than the length dimension of the device layer stack 4. Thereby, the end walls of the device layer stack 4 may remain covered by the dummy layer 14. As may be understood from the following discussion, a difference between the width dimension of the gate cavity 16 and the length dimension of the device layer stack 4 may translate to an increased physical separation between the subsequently formed gate stack 20 (see Fig. 7a-c) and source/drain contacts 21, 22 (see Fig. 14a-c).

In the illustrated example, the gate cavity 16 extends across the device layer stack 4 so as to expose both lateral walls of the device layer stack 4. This facilitates forming of a device GAA gate stack. As further shown, the gate cavity 16 may extend across more than one device layer stack 4, such as two device layer stacks 4. This facilitates forming two relatively closely spaced 2D channel FETs having a common or shared gate stack, as will be shown in the following.

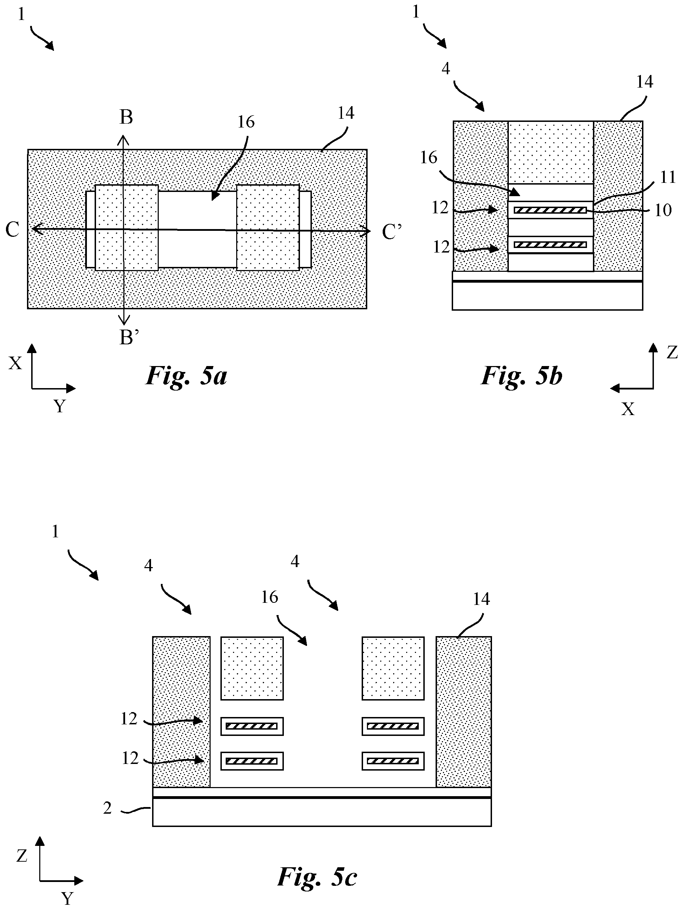

In Fig. 5a-c, the sacrificial layers 6 have been removed from the device layer stack 4 by selectively etching the sacrificial material from the gate cavity 16. The sacrificial layers 6 may thereby be removed selectively to the sub-stacks 12. Each sub-stack 12, comprising the channel layer 10 and the gate dielectric layer 11, may thus be released and become suspended within the gate cavity 16, between the first and second source/drain sides S1, S2.

The sub-stacks 12 may more specifically be suspended by any abutting portions of the dummy layer 14. Here, a further effect of forming the gate cavity 16 with a smaller width dimension than the length dimension of the device layer stack 4 may be appreciated, in that a greater difference may increase a contact interface between the sub-stacks 12 and the dummy layer 14 and hence more reliable securing of the sub-stacks 12.

If a further securing of the sub-stacks 12 is desired, an additional process step may be applied to the device layer stack 4 after the stage shown in Fig. 2a-c, and prior to forming the dummy layer 14, by recessing the sacrificial layers 6 from the end walls of the device layer stack 4. The recessing may be achieved by etching back the sacrificial layers 6 from the end walls using a suitable isotropic etching process, selective to the sacrificial material. To prevent recessing of the sacrificial layers 6 along the lateral walls of the device layer stack 4, the lateral walls of the device layer stack 4 may be masked by a temporary mask layer during the etch back. After the recessing, the dummy layer 14 may be formed to protrude into the recesses thus formed in the device layer stack 4, above and below the sub-stacks 12, and thus provide a further securing thereof.

By removing the sacrificial layers 6, the gate cavity 16 is as shown extended into the device layer stack 4 above and below the sub-stacks 12 comprising the channel layer 10 and the encapsulating gate dielectric layer 11.

The sacrificial layers 6 may be removed using any suitable conventional etching process with a sufficient selectivity towards the sacrificial material, relative the gate dielectric material, such that the sacrificial layers 6 may be removed without causing any appreciable etching or removal of the gate dielectric layer 11.

During and subsequent to the release process, the dielectric layer 11 encapsulating the channel layer 10 may mask the channel layer 10 and mitigate a risk of sagging of the channel layer 10.

Fig. 6a-c shows the device structure 1 after the sacrificial layers 6 have been removed and, subsequently, an oxide liner 18 has been formed along the sidewalls of the gate cavity 16.

The oxide liner 18 is formed by performing an oxidation process adapted to oxidize a thickness portion of the dummy layer 14 along the sidewalls of the gate cavity 16.

The oxidation process may be a plasma oxidation process using O₂ as oxidizing agent. The oxidation process may typically be performed at a relatively low temperature to mitigate a risk of causing oxidation of the 2D channel material. In particular, the oxidation process may be a room-temperature plasma oxidation process. A further example is an atmospheric-pressure plasma conducted at a temperature of 50 °C or lower.

During the plasma process, the oxidizing ambient may react with a thickness portion of the dummy semiconductor material of the dummy layer 14. The term "thickness portion" here refers to a depth of the surface oxidation caused by the oxidation process, i.e., as seen along a local surface normal of the dummy layer 14.

As per se is known in the art, the rate of oxidation, and thus growth rate of the oxide liner 18, may be varied by controlling parameters such as reactor temperature and concentration of oxidizing ambient in the reactor ambient.

The oxide liner 18 thus formed may as shown extend continuously along the sidewalls of the gate cavity 16 (e.g., the sidewalls 161, 162, 163, 164 as shown in Fig. 4a). This includes the surface portions of the dummy semiconductor material of the first and second sidewalls 161, 162 exposed when removing the sacrificial layers 6, as indicated by portions 18' in Fig. 6b.

Fig. 6a-c shows no growth of the oxide liner 18 along the top surface of the dummy layer 14. This may be achieved by preserving at least parts of the mask used to form the gate trench 16 during the oxidation process. The top surface of the dummy layer 14 may thus be masked from the oxidizing ambient and hence not oxidized by any appreciable extent. The mask may subsequently be removed to reveal the non-oxidized top surface of the dummy layer 14. This is however merely one example, and it is also possible to remove the mask prior to the oxidation process, wherein the oxide liner 18 may be formed also along the top surface of the dummy layer 14.

In Fig. 7a-c, a gate stack 20 has been formed in the gate cavity 16. The gate stack 20 surrounds the channel layer 10 and the gate dielectric layer 11 of each sub-stack 12 along the channel region. The gate stack 20 is separated from the dummy layer 14 by the oxide liner 18.

Since the gate dielectric layer 11 in the illustrated example already is present on each channel layer 10, the gate stack 20 in this example refers to the conductive gate body, or gate electrode. Accordingly, the gate stack 20 may comprise one or more conductive layers, typically one or more gate metal layers, however highly doped polysilicon is also a possibility.

Examples of gate metal layers include one or work function metals (e.g. Ti, TiAl, TiAlC, TiN, TaN, Mo, MoN, deposited by ALD), and/or a gate fill metal such as W, Mo, Al, Co or Ru. The gate fill metal may for instance be deposited by CVD, ALD or PVD. After deposition, the deposited gate metal layer(s) may be planarized (e.g., by CMP and/or metal etch back) to remove overburden metal deposited outside the gate cavity 16, and thus arrive at the device structure 1 as shown in Fig. 7a-c. The planarization may for example be stopped on the top surface of the hard mask 12.

Since the gate cavity 16, as discussed above, in the illustrated example has been formed to extend across the device layer stack 4 and thus expose both lateral walls of the device layer stack 4, the gate stack 20 correspondingly has a non-zero gate extension past both lateral walls of the device layer stack 4. The gate stack 20 hence defines a GAA with respect to the channel layers 10.

The dimension of the gate extension past any of the lateral walls of the device layer stack 4 will substantially correspond to the corresponding extension of the gate cavity 16 minus any "trimming" of the gate cavity 16 caused by the growth of the oxide liner 18.

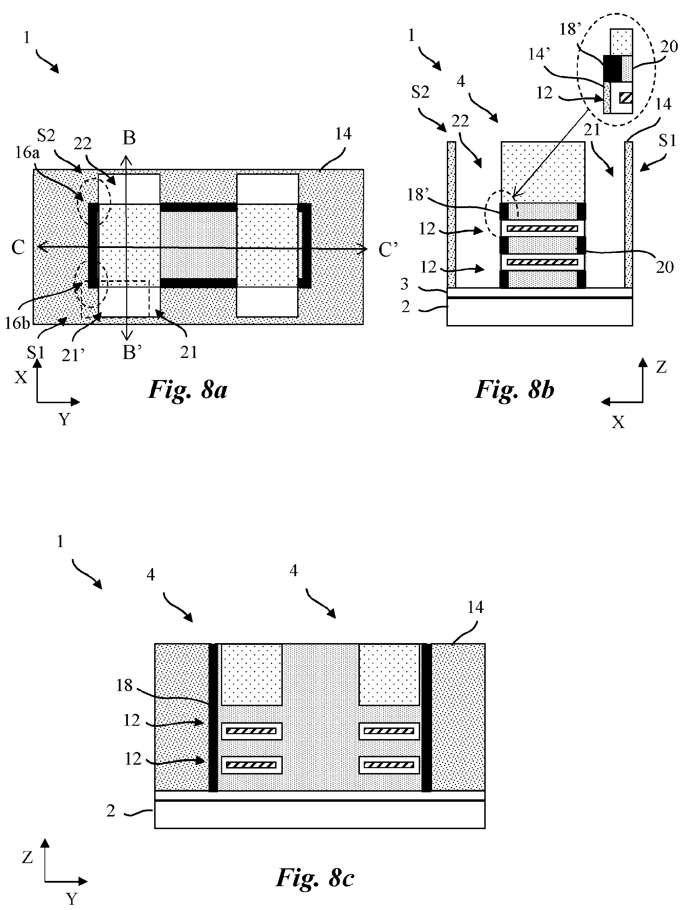

In Fig. 8a-c, source/drain contact cavities 21, 22 have been formed in the dummy layer 14, on the first and second source/drain sides S1, S2, respectively.

The gate cavity 16 may be formed by a lithography and etching process. Any suitable conventional etching process, isotropic or anisotropic, wet or dry, with a sufficient selectivity towards the dummy semiconductor material may be used. The etch may be stopped on the substrate 2 or, where present, the insulating layer 3.

The first source/drain contact cavity 21 is formed along and exposes the end wall of the device layer stack 4 facing the first source/drain side S1. The second source/drain contact cavity 22 is formed along and exposes the end wall of the device layer stack 4 facing the second source/drain side S2.

In the illustrated example, the source/drain contact cavities 21, 22 are each formed with a width dimension (along the second direction Y) corresponding to, or being substantially equal to, the width dimension of the device layer stack 4. Wider source/drain contact cavities may enable a greater contact interface between the channel layer 10 and the subsequently formed source/drain contacts.

Due to the presence of the oxide liner 18, the source/drain contact cavities 21, 22 may as shown at no location expose the gate stack 20. In particular, from the first and second source/drain sides S1, S2 the source/drain contact cavities may be separated from the gate stack 20 by the oxide liner portions 18'.

In the illustrated example, the source/drain contact cavities 21, 22 are each formed to be adjacent or neighboring to a respective one of the corner regions 16a, 16b but do not extend past the corner regions 16a, 16b. However, the roadmap for advanced technology nodes envisages devices with very small (e.g., by way of example 5 nm or less, such as 2 nm or less or 1 nm or less) or even zero gate extensions. The significance of the oxide liner 18 may here be appreciated considering that a smaller gate extension reduces the tolerance for alignment errors when forming the source/drain contact cavities 21, 22. For instance, an edge placement error during lithography for patterning the source/drain contact cavities 21, 22 may result in one or both of the source/drain cavities 21, 22 being displaced so as to extend past the respective corner regions 16a, 16b. This is in Fig. 8a schematically indicated by the dashed rectangular outline 21' representing an outline of such a displaced first source/drain cavity extending past the corner region 16a. Accordingly, absence of the oxide liner 18 along the third sidewall 163 of the gate trench 16 and the corresponding sidewall of the gate stack 20, there would be a considerable risk of exposing the gate stack 20 from the source/drain contact trench 21'. This may in turn result in a risk of an electrical short, or insufficient spacing and isolation margin, between the gate stack 20 and the source/drain contact subsequently formed therein.

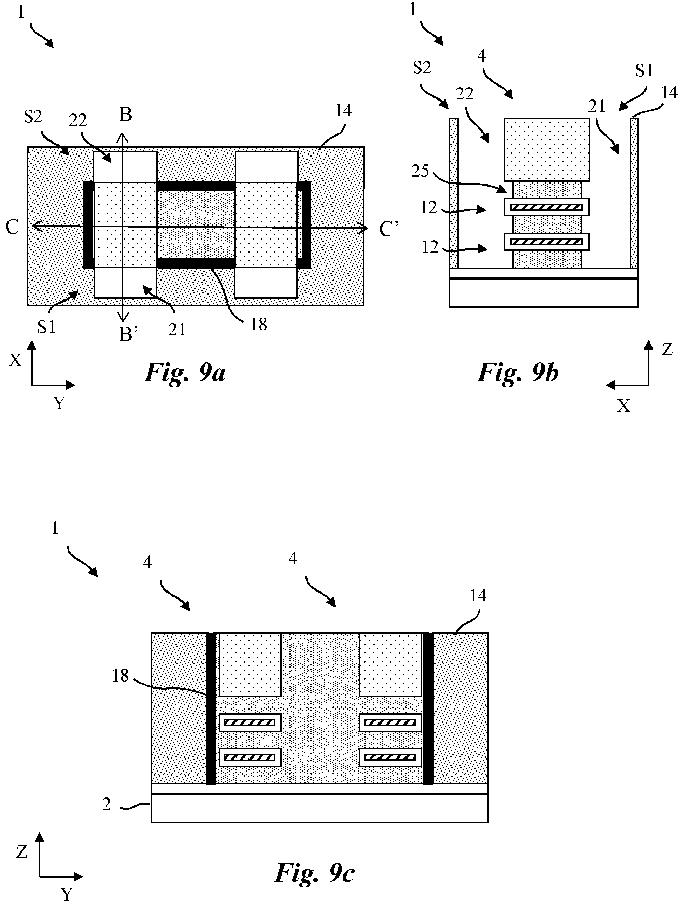

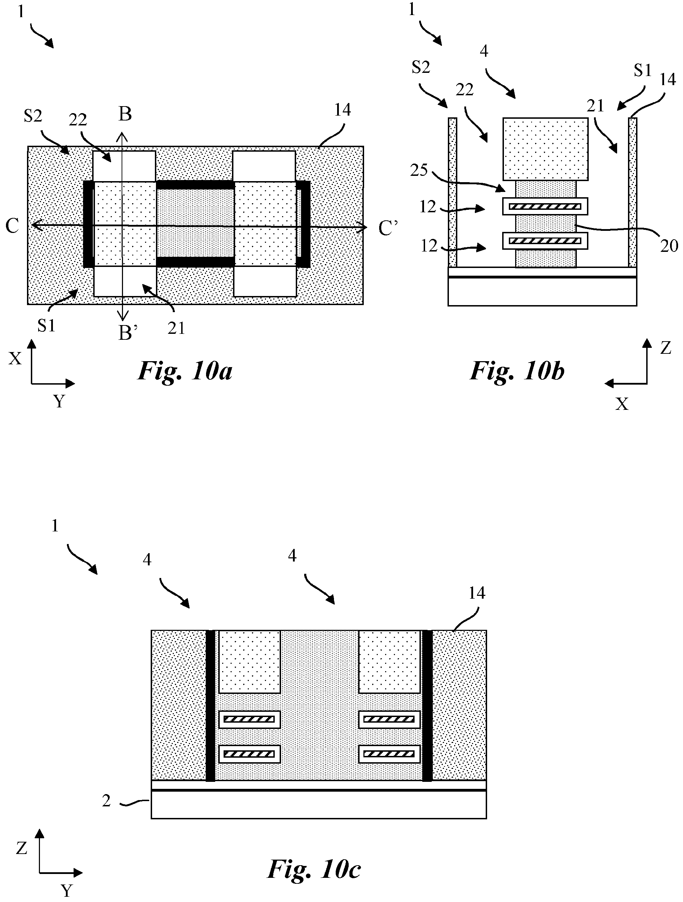

Fig. 9a-c and 10a-c show process steps performed after forming the source/drain contact cavities 21, 22 and prior to forming the source/drain contacts 31, 32, for forming recesses 25 for inner spacers, herein termed "source/drain recesses 25".

In Fig. 9a-c the oxide liner 18, more specifically the oxide liner portions 18' shown in Fig. 8b, has/have first been recessed from the source/drain contact cavities 21, 22 to expose sidewall portions of the gate stack 20. In Fig. 10a-c, the exposed sidewall portions of the gate stack 20 have subsequently been recessed to form the source/drain recesses 25.

The oxide liner 18 and the gate stack 20 may each be recessed using any (respective) suitable conventional isotropic etching process, wet or dry, with a sufficient etch selectivity towards the respective materials.

The recessing may serve to enable a further increased physical spacing between the subsequently formed source/drain contacts 31, 32 and the gate stack 20, beyond the spacing already enabled by the oxide liner 18.

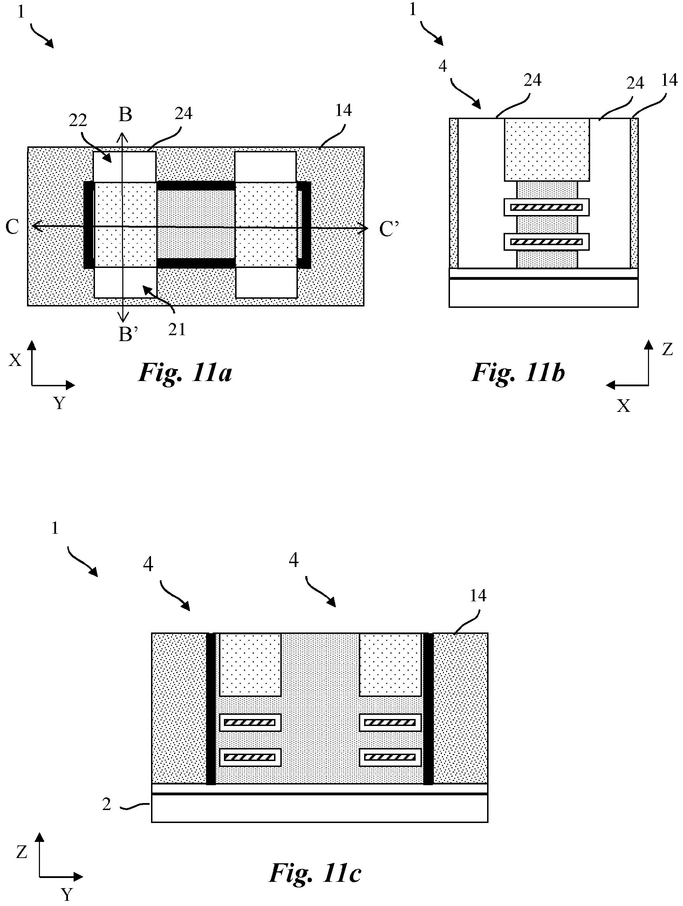

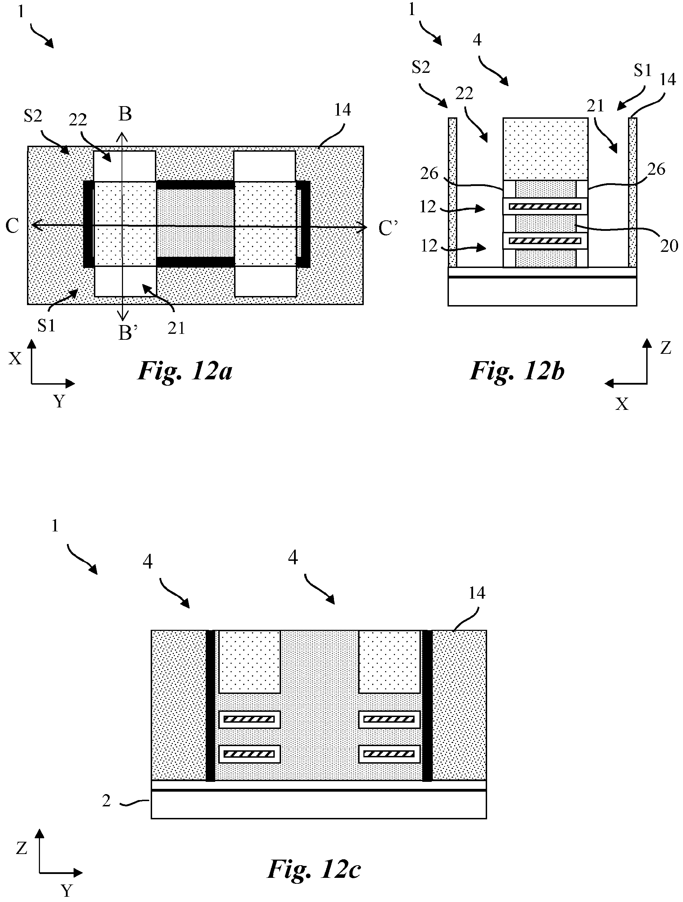

Fig. 11a-c and 12 a-c show process steps for forming inner spacers 26 covering the recessed sidewall portions of the gate stack 20 and filling the source/drain recesses 25.

In Fig. 11a-c, an insulating inner spacer material 24 has been deposited to fill the source/drain contact trenches 21, 22 and the source/drain recesses 25. Any suitable dielectric material conventionally used as inner spacer material may be used, e.g., oxides and/or nitrides, typically of a low-k. The inner spacer material 24 may be deposited using a suitable conventional process such as CVD or PVD.

In Fig. 12a-c, the inner spacer material 24 has been etched such that the inner spacer material deposited outside the source/drain recesses 25 is removed but preserved in the source/drain recesses 25 to form the inner spacers 26. Any conventional etching process allowing the inner spacer material 24 to be etched anisotropically in a top-down direction (along the vertical direction Z) may be employed.

In another example, the inner spacer material 24 may instead be deposited conformally, e.g., by ALD, to fill the source/drain recesses 25. Portions of the inner spacer material 24 deposited outside the source/drain recesses 25 may subsequently be removed by etching, e.g., an anisotropic etch, or an isotropic etch.

In either case, the removed portions of the oxide liner 18' may hence be replaced with inner spacers 26 adjoining the remaining the portions of the oxide liner 18 not being removed during the oxide liner recess step. However, due to the preceding recess of the gate stack 20, a thickness of the inner spacers 26 (e.g., along the first direction X) may exceed that of the oxide liner 18.

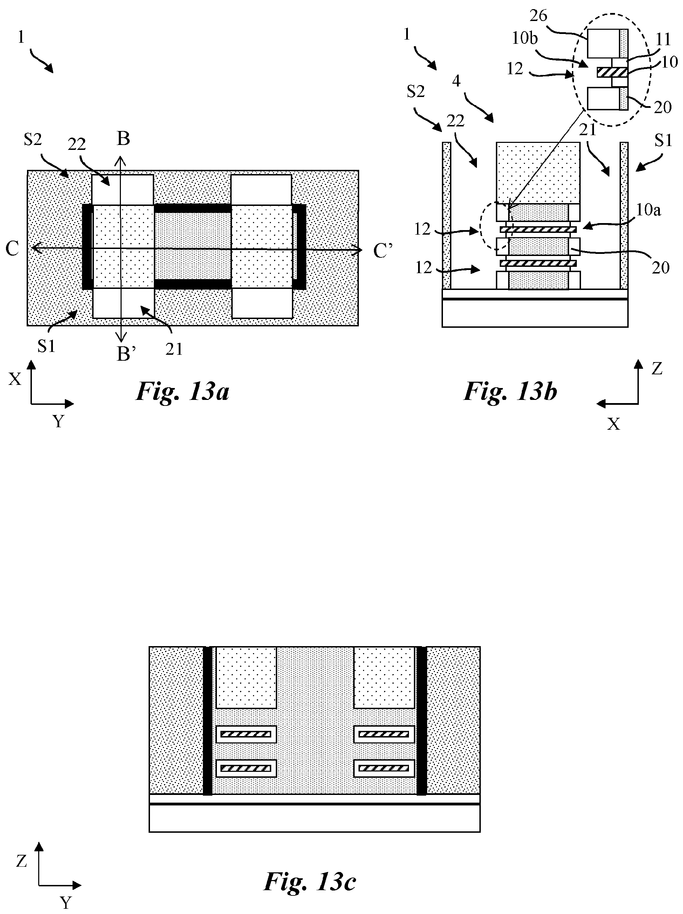

In Fig. 13a-c, the gate dielectric layer 11 has after forming the inner spacers 26 been recessed to expose the first and second end portions 10a, 10b of the channel layer 10. The channel layer 10 may thus be prepared for the subsequent contacting with the source/drain contacts 31, 32.

The gate dielectric layer 11 may be recessed using an etching process etching the gate dielectric material selective to the inner spacer material and the 2D channel material. For example, any suitable conventional isotropic etching process, wet or dry, with a sufficient selectivity towards the gate dielectric material may be used.

As more clearly shown in the enlargement of the inset of Fig. 13b, the gate dielectric layer 11 may be recessed such that upper and lower surface portions of the end portions 10a, 10b are exposed. This enables forming the source/drain contacts 31, 32 as wrap-around contacts, with a larger contact interface. However, a side contact approach is also possible, wherein it may suffice to stop the recess of the gate dielectric layer 11 as soon as end portions 10a, 10b of the channel layer 10 are exposed. In any case, the depth of the recessing of the gate dielectric layer 11 should not so as to expose the gate stack 20.

As shown in the enlargement of the inset of Fig. 8b, there may following the forming of the source/drain contact cavities 21, 22 remain trace amounts of dummy semiconductor material 14' on the end surfaces of the sub-stacks 12 facing the respective trenches 21, 22. This may be due to the portions 14' of the dummy layer being shadowed by a slight lateral protrusion of the oxide liner portions 18' relative the end surfaces of the sub-stacks 12. Hence, the recessing of the gate dielectric layer 11 may be preceded by a recess (e.g., lateral etch back) of such trace amounts of dummy semiconductor material 14'. Any suitable conventional isotropic etching process, wet or dry, with a sufficient selectivity to the dummy semiconductor material may be used for this purpose.

In Fig. 14a-c, source/drain contacts 31, 32 have been formed in the source/drain contact cavities 21, 22. The source/drain contacts 31, 32 have been formed in contact with the channel layer 10, more specifically in contact with the end portions 10a, 10b exposed in the preceding step.

The source/drain contacts 31, 32 may be formed by one or more conductive contact materials, typically metals. Examples of contact metals include Ti, Bi, Sb, Ni, Pd pure or alloyed. As per se is known in the art, the contact metal may generally be selected in accordance with the conductivity type of the device being formed, e.g., N-type or P-type. A remaining portion, i.e. a portion not filled by the preceding contact metal(s) may be filled by a fill metal, for example comprise W, Al, Au or Ag. The contact metal(s) may be deposited using any suitable conventional deposition process, such as PVD, CVD and/or ALD. After deposition, overburden contact metal may be recessed by chemical mechanical polishing (CMP) and/or metal etch back, and thus arrive at the device structure 1 as shown in Fig. 14a-c.

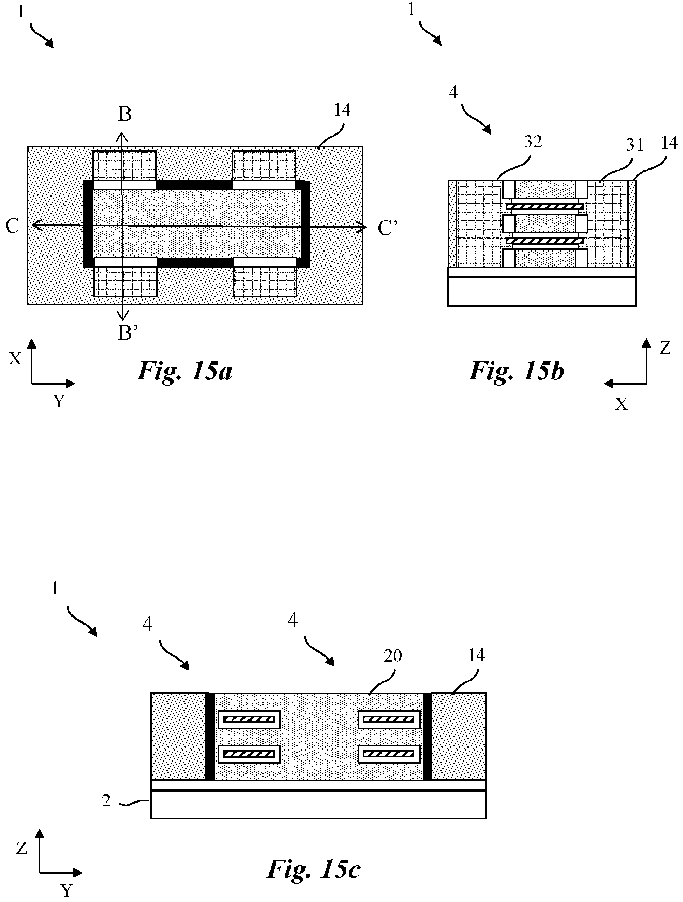

In Fig. 15a-c the device structure 1 has been subjected to a planarization process, to reduce a height of the source/drain contacts 31, 32 and the gate stack 20 to a final target height. The hard mask 12 may during this step also be removed.

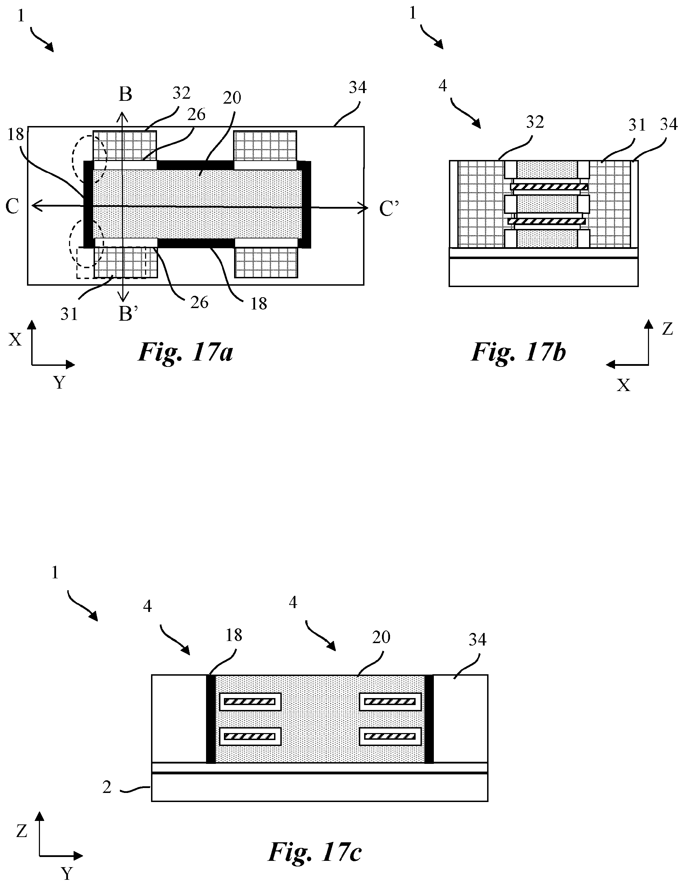

Fig. 16a-c and Fig. 17a-c depict process steps for replacing the dummy layer 14 with a dielectric layer 34.

In Fig. 16a-c the dummy layer 14 has been removed by etching away any remaining portions of the dummy semiconductor material. An isotropic etch process, wet or dry, with a sufficient selectivity to the dummy semiconductor material may be used for this purpose.

In Fig. 17a-c, the dielectric layer 34 has been formed by depositing one or more dielectric materials over the device structure 1 to embed the source/drain contacts 31, 32, the gate stack 20 therein. The dielectric layer 34 may be formed of any suitable dielectric materials conventionally used as inter-layer dielectric, such as silicon oxide or some other low-k dielectric. Further, the deposited dielectric materials may be planarized (e.g., CMP and/or etch back) to bring the top surface of the dielectric layer 34 flush with the top surface of the source/drain contacts 31, 32 and the gate stack 20.

Process steps of a method of a second approach which may be applied to the device structure 1 comprising the substrate 2 and the device layer stack 4, as shown in Fig. 2a-c, will now be disclosed with reference to Fig. 17a-c through Fig. 26a-c.

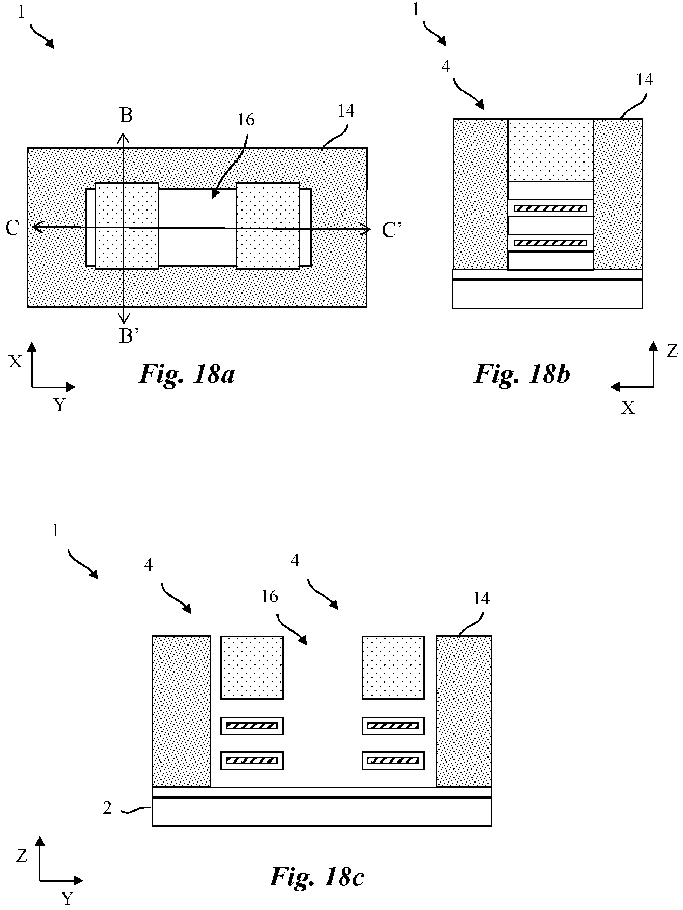

The second approach generally proceeds in correspondence to the first approach up to and including the channel release. Fig. 18a accordingly shows the device structure 1 and the device layer stack 4 at a stage after the sacrificial layers 6 have been removed.

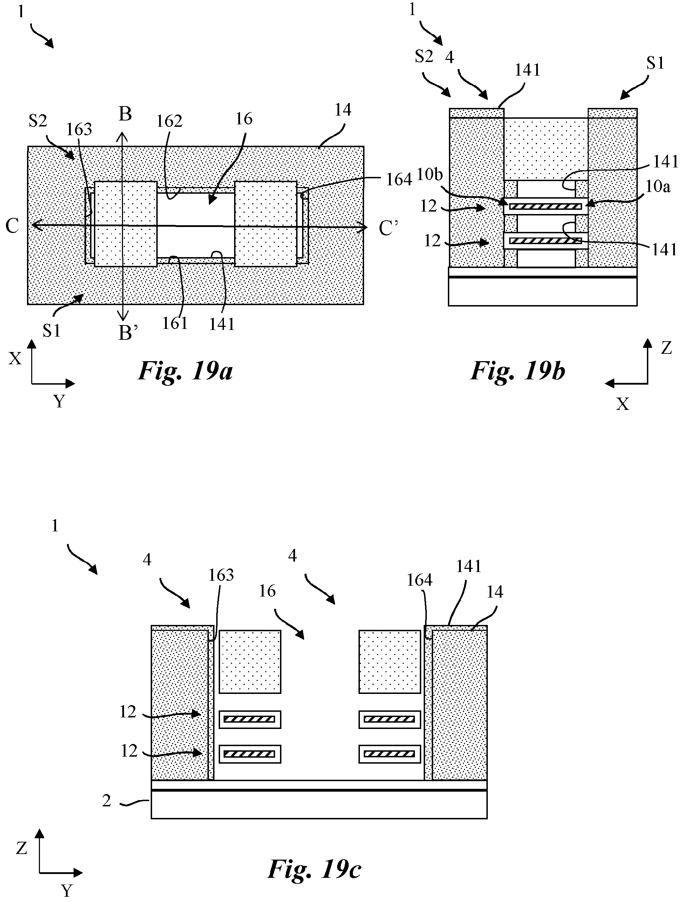

Fig. 19a-c shows the device structure 1 after removing the sacrificial layers 6 and prior to forming the oxide liner 18, wherein the dummy layer 14 further has been extended by selectively growing an auxiliary dummy semiconductor material 141 on the dummy layer 14, including on the first through fourth sidewalls 161, 162, 163, 164 of the gate cavity 16.

As shown, the auxiliary dummy semiconductor material 141 may thus grow laterally from the first and second sidewalls 161, 162 to surround the first and second end portions 10a, 10b of the channel layer 10 of the each sub-stack 12 from above and below.

The auxiliary dummy semiconductor material 141 may be of a same or similar species as the (first) dummy semiconductor material of the dummy layer 14. For instance, the auxiliary dummy semiconductor material 141 may be epitaxial Si, Ge or SiGe, or a-Si, or some other 3D or bulk semiconductor which may be grown or deposited in an area selective manner on the dummy layer 18. Selective deposition by PVD, CVD or ALD is possible. In either case, the auxiliary dummy semiconductor material 141 may seed from exposed surface portions of the first dummy semiconductor material of the dummy layer 14.

The auxiliary dummy semiconductor material 141 may be formed with a thickness corresponding to a desired separation between the gate stack 20 and the source/drain contacts 31, 32 which are to be formed. For example, the auxiliary dummy semiconductor material 141 may be formed with a thickness in a range of 1 to a few nm, such as 1-3 nm, e.g., depending also on a length dimension of the channel layer 10.

In either case growth of the auxiliary dummy semiconductor material 141 on the sidewalls 161, 162, 163, 164 of the gate trench 16 results in a trimming of the length and width dimensions of the gate trench 16.

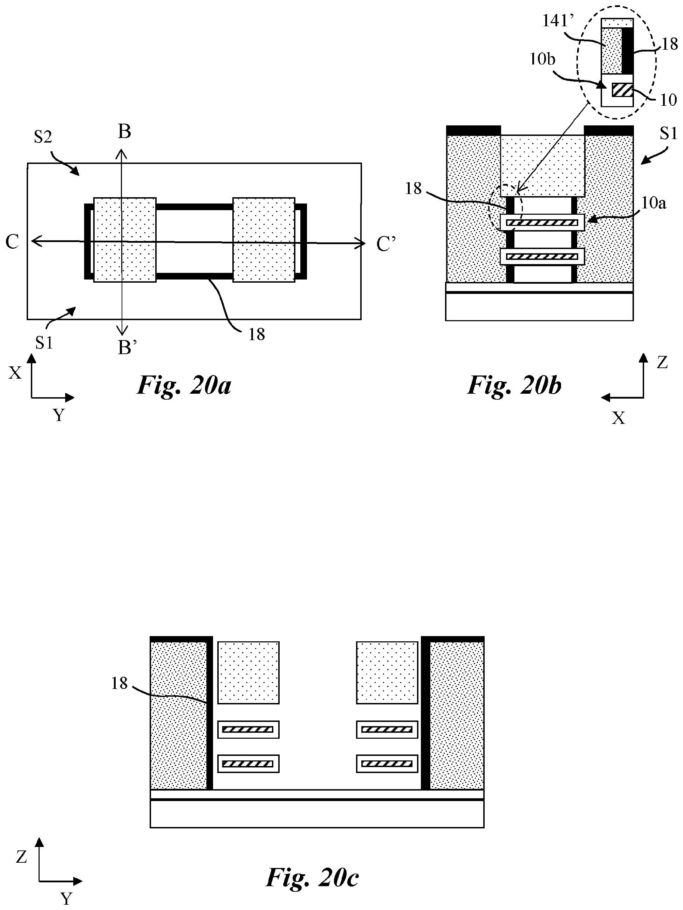

In Fig. 20a-c an oxide liner 18 has been formed along the sidewalls of the gate cavity 16. For illustrative purposes, the oxide liner 18 is in Fig. 20a only indicated along the sidewalls of the gate cavity 16 and omitted from the top surface of the dummy layer 14. The oxide liner 18 in the second approach generally corresponds to and may be formed in the corresponding manner to the oxide liner 18 in the first approach, i.e., using an oxidation process. However, in contrast to the first approach where the oxide liner 18 is formed by oxidizing a thickness portion of the first dummy semiconductor material, the oxide liner 18 is according to the second approach formed by oxidizing a thickness portion of the further auxiliary dummy semiconductor material 141 of the (extended) dummy layer 14.

In the illustrated example, there is in Fig. 20a-c shown forming of the oxide liner 18 along the top surface of the dummy layer 14. Fig. 19a-c further shows a deposition of auxiliary dummy semiconductor material 141 on the top surface of the dummy layer 14. If either of these results are not desired, it is as was discussed in connection with the first approach and Fig. 6a-c possible to preserve at least a portion of a mask used to form the gate cavity 16. The mask may be removed subsequent to completing the oxidation process.

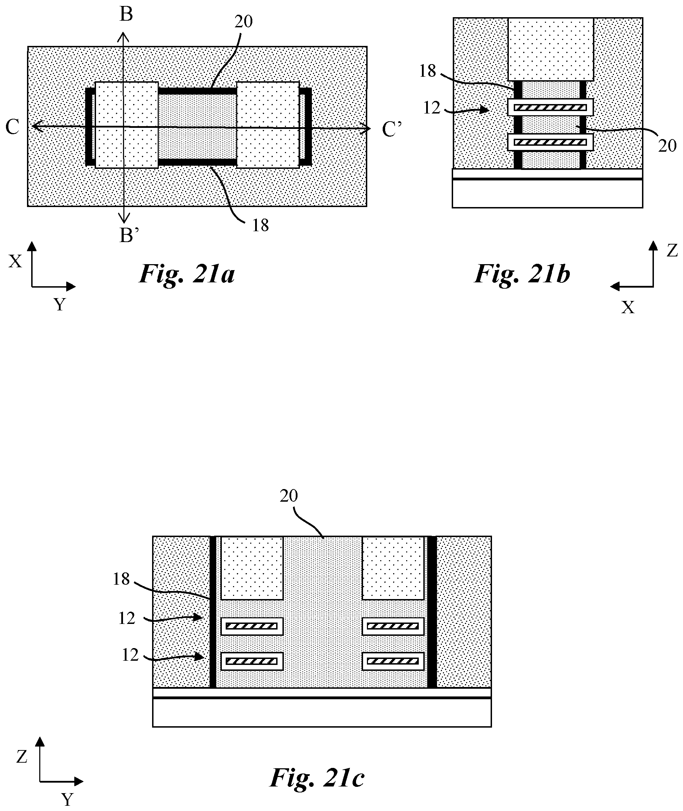

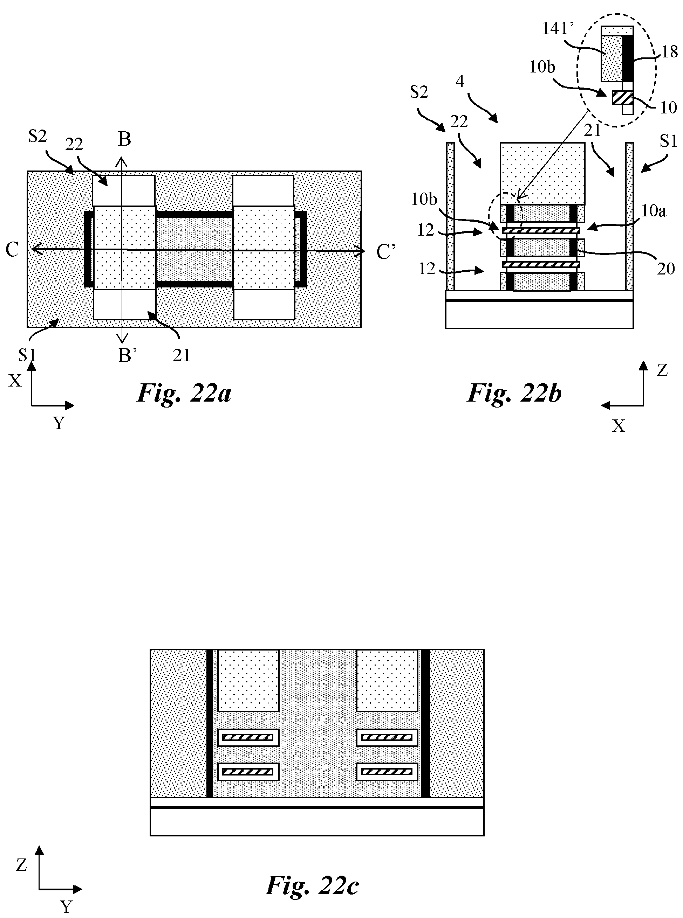

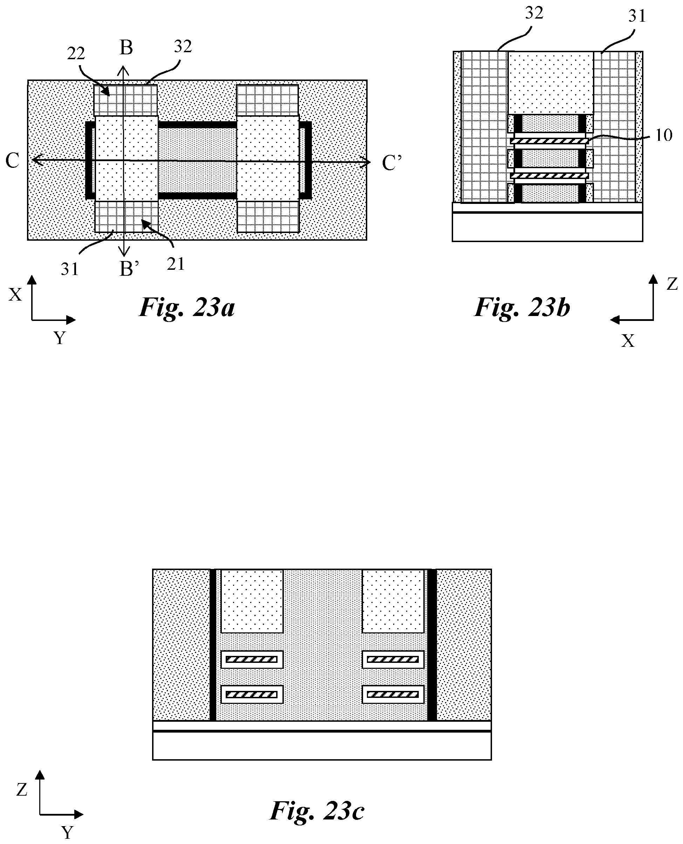

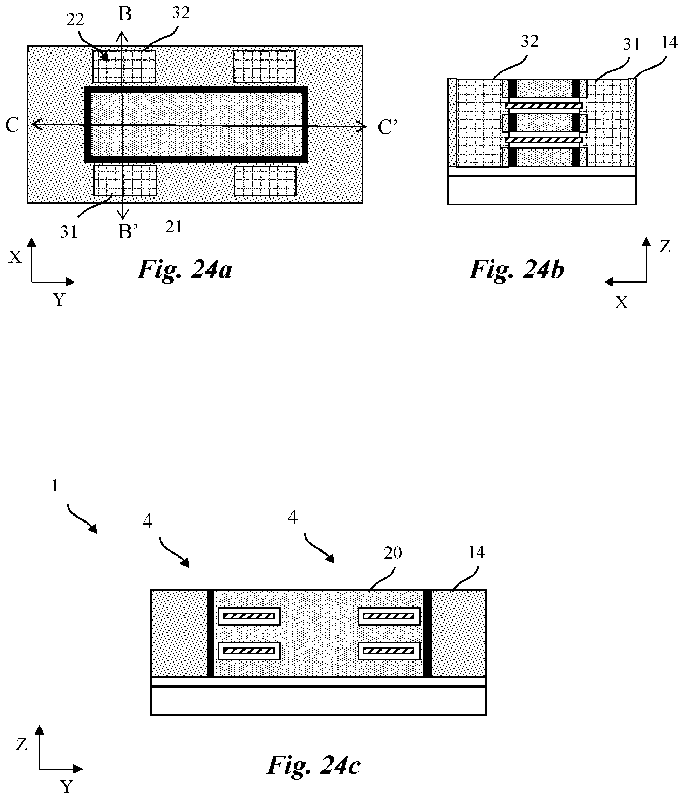

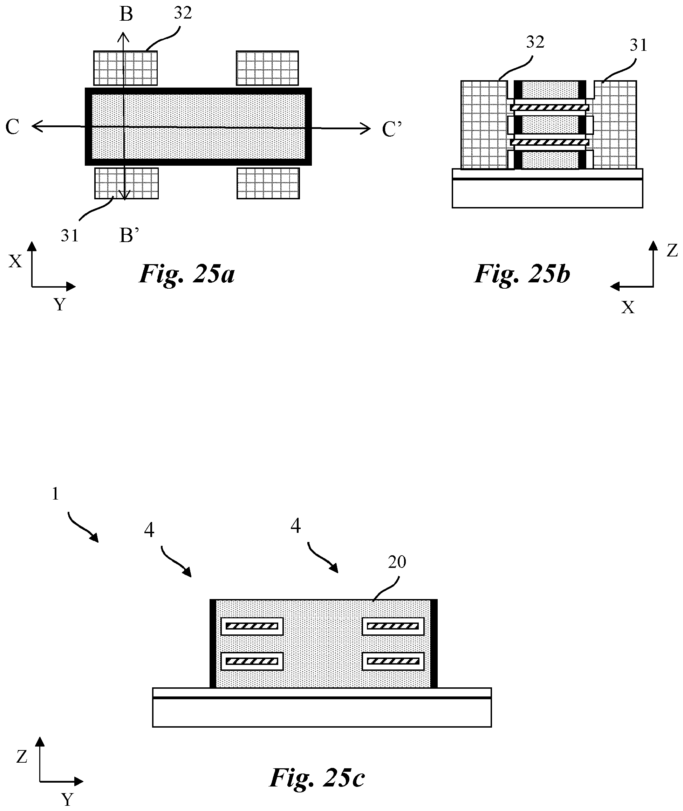

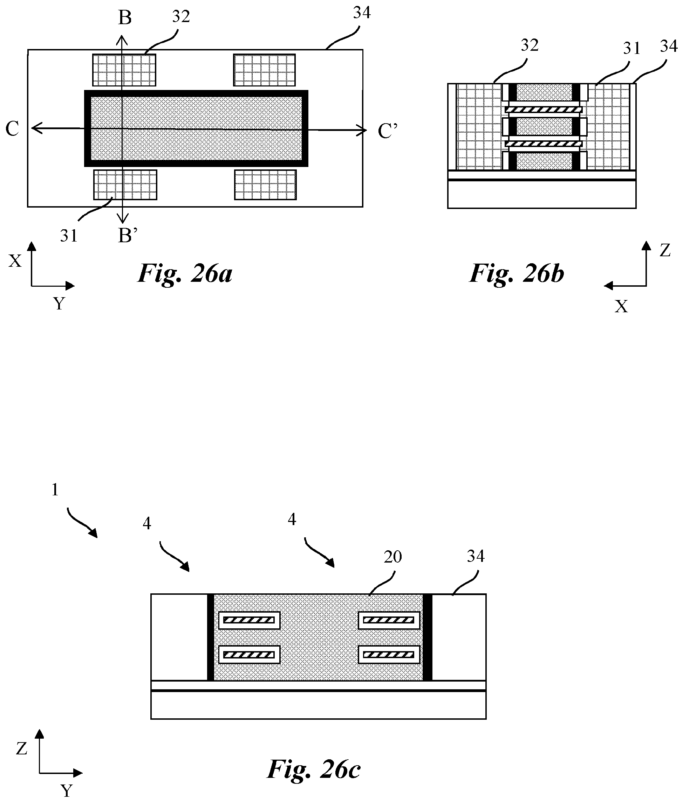

After forming the oxide liner 18, the method of the second approach generally proceeds in analogously to the first approach, e.g., by forming the gate stack 20 (Fig. 21a-c), forming source/drain contact cavities 21, 22 (Fig. 22a-c), forming source/drain contacts 31, 32 (Fig. 23a-c), planarizing the device structure 1 (Fig. 24a-c) and replacing the dummy layer 14 with a dielectric layer 34 (Fig. 25a-c and Fig. 26a-c).

There are however some minor differences caused by the additional deposition of the auxiliary dummy semiconductor material 141. As shown in the enlargement in the inset of Fig. 22b, the oxidation of the auxiliary dummy semiconductor material 141 may be only partial, such that there remains a non-oxidized thickness portion 141' of the auxiliary dummy semiconductor material 141 upon completion of the oxidation process. Accordingly, the source/drain contact cavities 21, 22 may be separated from the gate stack 20 by the oxide liner 18 and the remaining non-oxidized thickness portion 141'. This applies correspondingly to the source/drain contacts 31, 32, as shown in Fig. 24b.

As further shown in Fig. 25a-c and 26a-c, such remaining non-oxidized thickness portions 141' may further be removed together with the first dummy semiconductor material, and replaced with material of the dielectric layer 34.

Additionally, regardless of whether the auxiliary dummy semiconductor material 141 is partial or complete, the oxide liner 18 is in the second approach preserved in the final device structure 1, as shown in Fig. 26a-c, and hence provides a function of acting as an inner spacer between the source/drain contacts 31, 32 and the gate stack 20.

Resulting device structures 1 as shown in either of Fig. 17a-c and 26a-c have a common or shared gate stack. By forming one of the transistors as a P-type FET and the other as an N-type FET, the device structure 1 may implement a CMOS inverter.

The illustrated process steps of the first and second approaches may each be followed with additional conventional device fabrication steps, such as capping of the source/drain contacts and/or gate stack 20, middle-end-of line processing to form local interconnects, back-end-of-line processing, etc.

The person skilled in the art realizes that the present invention by no means is limited to the examples described above. On the contrary, many modifications and variations are possible within the scope of the appended claims.

For example, while Fig. 2a-c show how the channel layers 10 are fully encapsulated by respective dielectric layers 11, it is also possible to cap the channel layers 10 only along the lateral walls of the device layer stack 4 such that the end portions 10a, 10b of the channel layers 10 remain laid bare. This may be achieved by masking the end walls the device layer stack 10 facing the first and second source/drain sides S1, S2 with a temporary mask layer during the recess step, such that the channel layer 10, and optionally dielectric layers 9, are laterally etch backed back only from lateral walls of the device layer stack 4. Doing so, the recessing of the gate dielectric layer 11 prior to forming the source/drain contacts 31, 32, as shown in Fig. 13a-c and 22a-c, may be obviated.

Furthermore, it is contemplated that the method of the present disclosure may be applied to a device layer stack initially comprising no gate dielectric layers, but simply an alternating stack of sacrificial layers (corresponding to sacrificial layers 6) and channel layers (corresponding to channel layers 10). The oxide liner may be formed as discussed above, after removing the sacrificial layers. A gate dielectric may subsequently be formed to surround the channel layers as part of forming the gate stack.

Furthermore, in the illustrated examples, the gate cavity 16 extends across the device layer stack 4 so as to expose both lateral walls of the device layer stack 4. This facilitates forming of a device with a gate stack of a GAA configuration. A gate stack of a GAA configuration has a non-zero gate extension on either lateral side of the channel region of the device. However, in other examples the gate cavity 16 may be formed to expose only one of the lateral walls of the device layer stack 4. This facilitates forming of a device of a gate stack of "forksheet" gate configuration. A gate stack of a forksheet has a non-zero gate extension on only one lateral side of the channel region of the device and a zero or substantially zero gate extension on the opposite lateral side of the channel region. As per se is known in the art, such a forksheet configuration enables aggressive scaling of the device separation at the p-n boundary.

## Claims

1. A method for forming a 2D channel field-effect transistor device (1), the method comprising:
forming a device layer stack (4) on a substrate (2), the device layer stack (4) comprising lower and upper sacrificial layers (6) of a sacrificial material and a channel layer (10) of a 2D material arranged between the lower and upper sacrificial layers (6), wherein the device layer stack (4) extends in a first direction between a first source/drain side (S1) and a second source/drain side (S2);
embedding the device layer stack (4) in a dummy layer (14) of a dummy semiconductor material;
forming a gate cavity (16) in the dummy layer (14), the gate cavity (16) extending in a second direction transverse to the first direction, and exposing the device layer stack (4) along a channel region between the first and second source/drain side (S1, S2);
removing the sacrificial layers (6) from the device layer stack (4) by selectively etching the sacrificial material from the gate cavity (16);
after removing the sacrificial layers (6), forming an oxide liner (18) along sidewalls of the gate cavity (16), wherein forming the oxide liner (18) comprises performing an oxidation process to oxidize a thickness portion of the dummy layer (14) along the sidewalls of the gate cavity (16);
forming a gate stack (20) in the gate cavity (16) to surround the channel layer (10) along the channel region, wherein the oxide liner (18) separates the gate stack (20) from the dummy layer (14);
forming source/drain contact cavities (21, 22) in the dummy layer (14), on the first and second source/drain sides (S1, S2);
forming source/drain contacts (31, 32) in the source/drain contact cavities (21, 22), in contact with the channel layer (10); and
after forming the source/drain contacts (31, 32), replacing the dummy layer (14) with a dielectric layer (34).

2. The method according to claim 1, wherein the oxidation process is a plasma oxidation process, such as a room-temperature plasma oxidation process.

3. The method according to any one of the preceding claims,
wherein the gate cavity (16) comprises first and second opposite sidewalls (161, 162) extending along the first and second source/drain sides (S1, S2), respectively, and third and fourth opposite sidewalls (163, 164) connecting the first and second sidewalls (161, 162) at opposite ends of the gate cavity (16), and
wherein the oxide liner (18) is formed to extend along each of the first, second, third and fourth sidewalls of the gate cavity (16).

4. The method according to claim 3,
wherein the third sidewall (163) connects to the first and second sidewalls (161, 162) in respective corner regions (16a, 16b) of the gate cavity (16), and
wherein the source/drain contact cavities (21, 22) are formed along the first and second sidewalls (161, 162) of the gate cavity (16), adjacent a respective one of the corner regions (16a, 16b).

5. The method according to claim **4,** wherein one, or both, of the source/drain contact cavities (21') extends past the respective corner region (16a).

6. The method according to any one of the preceding claims, wherein the device layer stack (4) further comprises a gate dielectric layer (11) encapsulating the channel layer (10), wherein the gate dielectric layer (11) and the channel layer (10) are arranged between the lower and upper sacrificial layers (6).

7. The method according to claim 6, wherein forming the device layer stack (4) comprises:
forming an initial device layer stack (4) comprising, in sequence, the lower sacrificial layer (6), a lower gate dielectric layer portion (9), the channel layer (10), an upper gate dielectric layer portion (9) and the upper sacrificial layer (6);
forming a recess (5) in the initial device layer stack (4) by etching back at least the channel layer (10), and optionally also the gate dielectric layer portions (9), relative the sacrificial layers (6); and
forming a side gate dielectric layer portion in the recess (5), wherein the side gate dielectric layer portion connects the upper and lower gate dielectric layer portions to form the gate dielectric layer (11) encapsulating the channel layer (10).

8. The method according to any one of claims 6-7, wherein the channel layer (10) comprises a first end portion facing the first source/drain side (S1) and a second end portion facing the second source/drain side (S2), and wherein the method further comprises recessing the gate dielectric layer (11) from the source/drain contact trenches (21, 22) to expose the first and second end portions of the channel layer (10), wherein the source/drain contacts (31, 32) subsequently are formed in the source/drain contact cavities (21, 22), in contact with the exposed first and second end portions of the channel layer (10).

9. The method according to any one of the preceding claims, further comprising:
after removing the sacrificial layers (6) and prior to forming the oxide liner (18), extending the dummy layer (14) by selectively growing an auxiliary dummy semiconductor material (141) on the dummy layer (14), including on the sidewalls of the gate cavity (16),
wherein the sidewalls of the gate cavity (16) comprise a first sidewall (161) extending along the first source/drain side (S1) and a second sidewall (162) extending along the second source/drain side (S2),
wherein the channel layer (10) comprises a first end portion (10a) facing the first source/drain side (S1) and a second end portion (10b) facing the second source/drain side (S2),
wherein the auxiliary dummy semiconductor material (141) grows laterally from the first and second sidewalls (161, 162) to surround the first and second end portions (10a, 10b) of the channel layer (10) from above and below, and
wherein the thickness portion of the dummy layer (14) oxidized when performing the oxidation process comprises a thickness portion of the auxiliary dummy semiconductor material (141).

10. The method according to claim 9, wherein the source/drain contact cavities (21, 22) in the dummy layer (14) are separated from the gate stack (20) by the oxide liner and a non-oxidized thickness portion (141') of the auxiliary dummy semiconductor material (141).

11. The method according to claim 10, wherein replacing the dummy layer (14) with a dielectric layer (34) comprises removing the dummy layer (14), including the non-oxidized thickness portion (141'), using a selective etching process, and subsequently depositing the dielectric layer (34).

12. The method according to any one of claims 1-8, further comprising, after forming the source/drain contact cavities (21, 22) and prior to forming the source/drain contacts (31, 32):
recessing the oxide liner (18) from the source/drain contact cavities (21, 22) to expose sidewall portions of the gate stack (20) and subsequently recessing the exposed sidewall portions of the gate stack (20), to form source/drain recesses (25); and
forming inner spacers (26) covering the recessed sidewall portions of the gate stack (20) and filling the source/drain recesses (25).

13. The method according to claim 12, when dependent on claim 8, wherein the gate dielectric layer (11) is recessed to expose the first and second end portions (10a, 10b) of the channel layer (10) after forming the inner spacers (26).

14. The method according to any one of the preceding claims, wherein the 2D channel material is a transition metal dichalcogenide, such as molybdenum disulfide, tungsten disulfide, molybdenum diselenide or tungsten diselenide.

## Patentansprüche

1. Verfahren zum Bilden eines 2D-Kanal-Feldeffekttransistor-Bauelements (1), wobei das Verfahren umfasst:
Bilden eines Bauelementschichtstapels (4) auf einem Substrat (2), wobei der Bauelementschichtstapel (4) untere und obere Opferschichten (6) aus einem Opfermaterial und eine Kanalschicht (10) aus einem 2D-Material, das zwischen den unteren und oberen Opferschichten (6) angeordnet ist, umfasst, wobei sich der Bauelementschichtstapel (4) in einer ersten Richtung zwischen einer ersten Source-/Drain-Seite (S1) und einer zweiten Source-/Drain-Seite (S2) erstreckt;
Einbetten des Bauelementschichtstapels (4) in eine Dummy-Schicht (14) aus einem Dummy-Halbleitermaterial;
Bilden eines Gate-Hohlraums (16) in der Dummy-Schicht (14), wobei sich der Gate-Hohlraum (16) in einer zweiten Richtung, die zu der ersten Richtung querliegt, erstreckt, und Freilegen des Bauelementschichtstapels (4) entlang eines Kanalbereichs zwischen der ersten und der zweiten Source-/Drain-Seite (S1, S2);
Entfernen der Opferschichten (6) von dem Bauelementschichtstapel (4) durch selektives Ätzen des Opfermaterials aus dem Gate-Hohlraum (16);
nach dem Entfernen der Opferschichten (6), Bilden eines Oxid-Liners (18) entlang der Seitenwände des Gate-Hohlraums (16), wobei das Bilden des Oxid-Liners (18) das Ausführen eines Oxidationsprozesses umfasst, um einen Dickenabschnitt der Dummy-Schicht (14) entlang der Seitenwände des Gate-Hohlraums (16) zu oxidieren;
Bilden eines Gate-Stapels (20) in dem Gate-Hohlraum (16), um die Kanalschicht (10) entlang des Kanalbereichs zu umgeben, wobei der Oxid-Liner (18) den Gate-Stapel (20) von der Dummy-Schicht (14) trennt;
Bilden von Source-/Drain-Kontakthohlräumen (21, 22) in der Dummy-Schicht (14) auf den ersten und zweiten Source-/Drain-Seiten (S1, S2);
Bilden von Source-/Drain-Kontakten (31, 32) in den Source-/Drain-Kontakthohlräumen (21, 22) in Kontakt mit der Kanalschicht (10); und
nach dem Bilden der Source-/Drain-Kontakte (31, 32), Ersetzen der Dummy-Schicht (14) durch eine Dielektrikumsschicht (34).

2. Verfahren nach Anspruch 1, wobei der Oxidationsprozess ein Plasmaoxidationsprozess, wie etwa ein Plasmaoxidationsprozess bei Raumtemperatur, ist.

3. Verfahren nach einem der vorhergehenden Ansprüche,
wobei der Gate-Hohlraum (16) erste und zweite gegenüberliegende Seitenwände (161, 162), die sich jeweils entlang der ersten und zweiten Source-/Drain-Seiten (S1, S2) erstrecken, und dritte und vierte gegenüberliegende Seitenwände (163, 164), welche die ersten und zweiten Seitenwände (161, 162) an gegenüberliegenden Enden des Gate-Hohlraums (16) verbinden, umfasst, und
wobei der Oxid-Liner (18) dazu gebildet ist, sich entlang jeder der ersten, zweiten, dritten und vierten Seitenwände des Gate-Hohlraums (16) zu erstrecken.

4. Verfahren nach Anspruch 3,
wobei die dritte Seitenwand (163) mit den ersten und zweiten Seitenwänden (161, 162) in jeweiligen Eckbereichen (16a, 16b) des Gate-Hohlraums (16) verbunden ist, und
wobei die Source-/Drain-Kontakthohlräume (21, 22) entlang der ersten und zweiten Seitenwände (161, 162) des Gate-Hohlraums (16) an einen jeweiligen der Eckbereiche (16a, 16b) angrenzend gebildet sind.

5. Verfahren nach Anspruch 4, wobei sich einer der Source-/Drain-Kontakthohlräume (21') oder beide an dem jeweiligen Eckbereich (16a) vorbei erstreckt bzw. erstrecken.

6. Verfahren nach einem der vorhergehenden Ansprüche, wobei der Bauelementschichtstapel (4) ferner eine Gate-Dielektrikumsschicht (11), welche die Kanalschicht (10) einkapselt, umfasst, wobei die Gate-Dielektrikumsschicht (11) und die Kanalschicht (10) zwischen den unteren und oberen Opferschichten (6) angeordnet sind.

7. Verfahren nach Anspruch 6, wobei das Bilden des Bauelementschichtstapels (4) umfasst:
Bilden eines anfänglichen Bauelementschichtstapels (4), welcher der Reihe nach die untere Opferschicht (6), einen unteren Abschnitt (9) der Gate-Dielektrikumsschicht, die Kanalschicht (10), einen oberen Abschnitt (9) der Gate-Dielektrikumsschicht und die obere Opferschicht (6) umfasst;
Bilden einer Vertiefung (5) in dem anfänglichen Bauelementschichtstapel (4) durch Rückätzen mindestens der Kanalschicht (10), und wahlweise auch der Abschnitte (9) der Gate-Dielektrikumsschicht, im Verhältnis zu den Opferschichten (6); und
Bilden eines Seitenabschnitts der Gate-Dielektrikumsschicht in der Vertiefung (5), wobei der Seitenabschnitt der Gate-Dielektrikumsschicht die oberen und unteren Abschnitte der Gate-Dielektrikumsschicht verbindet, um die Gate-Dielektrikumsschicht (11), welche die Kanalschicht (10) einkapselt, zu bilden.

8. Verfahren nach einem der Ansprüche 6 bis 7, wobei die Kanalschicht (10) einen ersten Endabschnitt, welcher der ersten Source-/Drain-Seite (S1) gegenübersteht, und einen zweiten Endabschnitt, welcher der zweiten Source-/Drain-Seite (S2) gegenübersteht, umfasst, und wobei das Verfahren ferner das Vertiefen der Gate-Dielektrikumsschicht (11) gegenüber den Source-/Drain-Kontaktgräben (21, 22) umfasst, um die ersten und zweiten Endabschnitte der Kanalschicht (10) freizulegen, wobei die Source-/Drain-Kontakte (31, 32) anschließend in den Source-/Drain-Kontakthohlräumen (21, 22) in Kontakt mit den freigelegten ersten und zweiten Endabschnitten der Kanalschicht (10) gebildet werden.

9. Verfahren nach einem der vorhergehenden Ansprüche, ferner umfassend:
nach dem Entfernen der Opferschichten (6) und vor dem Bilden des Oxid-Liners (18), Verlängern der Dummy-Schicht (14) durch selektives Ziehen eines Hilfs-Dummy-Halbleitermaterials (141) auf der Dummy-Schicht (14), einschließlich an den Seitenwänden des Gate-Hohlraums (16),
wobei die Seitenwände des Gate-Hohlraums (16) eine erste Seitenwand (161), die sich entlang der ersten Source-/Drain-Seite (S1) erstreckt, und eine zweite Seitenwand (162), die sich entlang der zweiten Source-/Drain-Seite (S2) erstreckt, umfassen,
wobei die Kanalschicht (10) einen ersten Endabschnitt (10a), welcher der ersten Source-/Drain-Seite (S1) gegenübersteht, und einen zweiten Endabschnitt (10b), welcher der zweiten Source-/Drain-Seite (S2) gegenübersteht, umfasst,
wobei das Hilfs-Dummy-Halbleitermaterial (141) seitlich von den ersten und zweiten Seitenwänden (161, 162) aus wächst, um die ersten und zweiten Endabschnitte (10a, 10b) der Kanalschicht (10) von oben und unten zu umgeben, und
wobei der Dickenabschnitt der Dummy-Schicht (14) oxidiert, wenn das Ausführen des Oxidationsprozesses einen Dickenabschnitt des Hilfs-Dummy-Halbleitermaterials (141) umfasst.

10. Verfahren nach Anspruch 9, wobei die Source-/Drain-Kontakthohlräume (21, 22) in der Dummy-Schicht (14) von dem Gate-Stapel (20) durch den Oxid-Liner und einen nicht oxidierten Dickenabschnitt (141') des Hilfs-Dummy-Halbleitermaterials (141) getrennt sind.

11. Verfahren nach Anspruch 10, wobei das Ersetzen der Dummy-Schicht (14) durch eine Dielektrikumsschicht (34) das Entfernen der Dummy-Schicht (14), einschließlich des nicht oxidierten Dickenabschnitts (141'), unter Verwendung eines selektiven Ätzprozesses und anschließendes Abscheiden der Dielektrikumsschicht (34) umfasst.

12. Verfahren nach einem der Ansprüche 1 bis 8, ferner umfassend, nach dem Bilden der Source-/Drain-Kontakthohlräume (21, 22) und vor dem Bilden der Source-/Drain-Kontakte (31, 32):
Vertiefen des Oxid-Liners (18) gegenüber den Source-/Drain-Kontakthohlräumen (21, 22), um Seitenwandabschnitte des Gate-Stapels (20) freizulegen, und anschließendes Vertiefen der freigelegten Seitenwandabschnitte des Gate-Stapels (20), um Source-/Drain-Vertiefungen (25) zu bilden; und
Bilden von inneren Abstandshaltern (26), welche die vertieften Seitenwandabschnitte des Gate-Stapels (20) abdecken, und Ausfüllen der Source-/Drain-Vertiefungen (25).

13. Verfahren nach Anspruch 12 in Abhängigkeit von Anspruch 8, wobei die Gate-Dielektrikumsschicht (11) vertieft wird, um die ersten und zweiten Endabschnitte (10a, 10b) der Kanalschicht (10) nach dem Bilden der inneren Abstandshalter (26) freizulegen.

14. Verfahren nach einem der vorhergehenden Ansprüche, wobei das 2D-Kanalmaterial ein Übergangsmetall-Dichalkogenid, wie etwa Molybdändisulfid, Wolframdisulfid, Molybdändiselenid oder Wolframdiselenid, ist.

## Revendications

1. Procédé de formation d'un transistor à effet de champ à canal bidimensionnel (2D) (1), le procédé comprenant :
la formation d'une pile de couches de dispositif (4) sur un substrat (2), la pile de couches de dispositif (4) comprenant des couches sacrificielles inférieure et supérieure (6) constituées d'un matériau sacrificiel et une couche de canal (10) constituée d'un matériau 2D, disposée entre lesdites couches sacrificielles inférieure et supérieure (6), dans lequel la pile de couches de dispositif (4) s'étend dans une première direction entre un premier côté de source/drain (S1) et un deuxième côté de source/drain (S2) ;
l'enrobage de la pile de couches de dispositif (4) dans une couche factice (14) constituée d'un matériau semi-conducteur factice ;
la formation d'une cavité de grille (16) dans la couche factice (14), la cavité de grille (16) s'étendant dans une deuxième direction transversale à la première direction et exposant la pile de couches de dispositif (4) le long d'une région de canal située entre les premier et deuxième côtés de source/drain (S1, S2) ;
le retrait des couches sacrificielles (6) de la pile de couches de dispositif (4) par gravure sélective du matériau sacrificiel depuis la cavité de grille (16) ;
après le retrait des couches sacrificielles (6), la formation d'un revêtement en oxyde (18) le long des parois latérales de la cavité de grille (16), dans lequel la formation du revêtement en oxyde (18) comprend la mise en œuvre d'un processus d'oxydation pour oxyder une partie d'épaisseur de la couche factice (14) le long des parois latérales de la cavité de grille (16) ;
la formation d'une pile de grille (20) dans la cavité de grille (16) pour entourer la couche de canal (10) le long de la région de canal, dans lequel le revêtement en oxyde (18) sépare la pile de grille (20) de la couche factice (14) ;
la formation de cavités de contact de source/drain (21, 22) dans la couche factice (14), sur les premier et deuxième côtés de source/drain (S1, S2) ;
la formation de contacts de source/drain (31, 32) dans les cavités de contact de source/drain (21, 22), en contact avec la couche de canal (10) ; et
après la formation des contacts de source/drain (31, 32), le remplacement de la couche factice (14) par une couche diélectrique (34).

2. Procédé selon la revendication 1, dans lequel le processus d'oxydation est un processus d'oxydation par plasma, tel qu'un processus d'oxydation par plasma à température ambiante.

3. Procédé selon une quelconque des revendications précédentes,
dans lequel la cavité de grille (16) comprend des première et deuxième parois latérales opposées (161, 162) s'étendant respectivement le long des premier et deuxième côtés de source/drain (S1, S2), ainsi que des troisième et quatrième parois latérales opposées (163, 164) raccordant les première et deuxième parois latérales (161, 162) aux extrémités opposées de la cavité de grille (16) et
dans lequel le revêtement en oxyde (18) est formé de manière à s'étendre le long de chacune des première, deuxième, troisième et quatrième parois latérales de la cavité de grille (16).

4. Procédé selon la revendication 3,
dans lequel la troisième paroi latérale (163) rejoint les première et deuxième parois latérales (161, 162) au niveau des régions d'angle respectives (16a, 16b) de la cavité de grille (16), et
dans lequel les cavités de contact de source/drain (21, 22) sont formées le long des première et deuxième parois latérales (161, 162) de la cavité de grille (16), au voisinage d'une des régions d'angle respectives (16a, 16b).

5. Procédé selon la revendication 4, dans lequel une, ou les deux, des cavités de contact de source/drain (21') s'étend au-delà de la région d'angle respective (16a).

6. Procédé selon une quelconque des revendications précédentes, dans lequel la pile de couches de dispositif (4) comprend en outre une couche diélectrique de grille (11) encapsulant la couche de canal (10), dans lequel la couche diélectrique de grille (11) et la couche de canal (10) sont disposées entre les couches sacrificielles inférieure et supérieure (6).

7. Procédé selon la revendication 6, dans lequel la formation de la pile de couches de dispositif (4) comprend :
la formation d'une pile de couches de dispositif initiale (4) comprenant, dans l'ordre, la couche sacrificielle inférieure (6), une partie inférieure de couche diélectrique de grille (9), la couche de canal (10), une partie supérieure de couche diélectrique de grille (9) et la couche sacrificielle supérieure (6) ;
la formation d'un évidement (5) dans la pile de couches de dispositif initiale (4) par gravure en retrait d'au moins la couche de canal (10) et éventuellement aussi des parties de couche diélectrique de grille (9), par rapport aux couches sacrificielles (6) ; et
la formation d'une partie latérale de couche diélectrique de grille dans l'évidement (5), dans lequel la partie latérale de couche diélectrique de grille raccorde les parties supérieure et inférieure de la couche diélectrique de grille pour former la couche diélectrique de grille (11) encapsulant la couche de canal (10).

8. Procédé selon une quelconque des revendications 6 à 7, dans lequel la couche de canal (10) comprend une première partie d'extrémité faisant face au premier côté de source/drain (S1) et une deuxième partie d'extrémité faisant face au deuxième côté de source/drain (S2) et dans lequel le procédé comprend en outre le retrait par gravure de la couche diélectrique de grille (11) depuis les tranchées de contact de source/drain (21, 22) afin d'exposer les première et deuxième parties d'extrémité de la couche de canal (10), dans lequel les contacts de source/drain (31, 32) sont ensuite formés dans les cavités de contact de source/drain (21, 22), en contact avec les première et deuxième parties d'extrémité exposées de la couche de canal (10).

9. Procédé selon une quelconque des revendications précédentes, comprenant en outre :
après le retrait des couches sacrificielles (6) et, avant la formation du revêtement en oxyde (18), l'extension de la couche factice (14) par croissance sélective d'un matériau semi-conducteur factice auxiliaire (141) sur la couche factice (14), y compris sur les parois latérales de la cavité de grille (16),
dans lequel les parois latérales de la cavité de grille (16) comprennent une première paroi latérale (161) s'étendant le long du premier côté de source/drain (S1) et une deuxième paroi latérale (162) s'étendant le long du deuxième côté de source/drain (S2),
dans lequel la couche de canal (10) comprend une première partie d'extrémité (10a) faisant face au premier côté de source/drain (S1) et une deuxième partie d'extrémité (10b) faisant face au deuxième côté de source/drain (S2),
dans lequel le matériau semi-conducteur factice auxiliaire (141) croît latéralement à partir des première et deuxième parois latérales (161, 162) pour entourer les première et deuxième parties d'extrémité (10a, 10b) de la couche de canal (10) par le dessus et par le dessous et
dans lequel la partie d'épaisseur de la couche factice (14) qui est oxydée lors de la mise en œuvre du procédé d'oxydation comprend une partie d'épaisseur du matériau semi-conducteur factice auxiliaire (141).

10. Procédé selon la revendication 9, dans lequel les cavités de contact de source/drain (21, 22) ménagées dans la couche factice (14) sont séparées de la pile de grille (20) par le revêtement en oxyde et par une partie d'épaisseur non oxydée (141') du matériau semi-conducteur factice auxiliaire (141).

11. Procédé selon la revendication 10, dans lequel le remplacement de la couche factice (14) par une couche diélectrique (34) comprend le retrait de la couche factice (14), y compris de la partie d'épaisseur non oxydée (141'), au moyen d'un procédé de gravure sélective, suivi du dépôt de la couche diélectrique (34).

12. Procédé selon une quelconque des revendications 1 à 8, comprenant en outre, après la formation des cavités de contact de source/drain (21, 22) et avant la formation des contacts de source/drain (31, 32) :
le retrait partiel du revêtement en oxyde (18) des cavités de contact de source/drain (21, 22) afin d'exposer des parties de parois latérales de la pile de grille (20), suivi du retrait partiel des parties exposées de parois latérales de la pile de grille (20), pour former des évidements de source/drain (25) ; et
la formation d'espaceurs internes (26) recouvrant les parties de parois latérales de la pile de grille (20) ayant subi un retrait partiel et le remplissage des évidements de source/drain (25).

13. Procédé selon la revendication 12, lorsqu'elle dépend de la revendication 8, dans lequel la couche diélectrique de grille (11) est soumise à un retrait partiel afin d'exposer les première et deuxième parties d'extrémité (10a, 10b) de la couche de canal (10) après la formation des espaceurs internes (26).

14. Procédé selon une quelconque des revendications précédentes, dans lequel le matériau de canal bidimensionnel (2D) est un dichalcogénure de métal de transition, tel que le disulfure de molybdène, le disulfure de tungstène, le diséléniure de molybdène ou le diséléniure de tungstène.
